# EUROPÄISCHE PATENTSCHRIFT

(11) **EP 1 355 314 B1**
(45) Veröffentlichungstag und Bekanntmachung des Hinweises auf die Patenterteilung: **19.03.2008**
(21) Anmeldenummer: 03008122.8
(22) Anmeldetag: 07.04.2003
(51) Int. Cl.: G11C 5/14, G11C 16/30, G11C 11/4074, H02M 3/07

(54) **Elektronische Schalteranordnung**
Electronic switch
Commutateur électronique

(30) Priorität: 18.04.2002 DE 10217293
(43) Veröffentlichungstag der Anmeldung: 22.10.2003
(73) Patentinhaber: Infineon Technologies AG, 81669 München (DE)
(72) Erfinder: Ausserlechner, Udo, Dr., 9500 Villach (AT)
(74) Vertreter: Zimmermann, Tankred Klaus

(56) Entgegenhaltungen:
- DE-A- 10 107 658
- US-A- 6 023 188

## Beschreibung

Die vorliegende Erfindung bezieht sich auf elektronische Schalteranordnungen, und insbesondere auf elektronische Schalteranordnungen, die vorgesehen sind, um eine hohe positive oder eine hohe negative Ausgangsspannung, die an einem Ausgang einer elektronischen Schaltung, wie z. B. einer elektronischen Ladungspumpe, bereitgestellt wird, an einen Schaltungsausgangsport durchzuschalten.

In der Technik werden Ladungspumpen beispielsweise dazu eingesetzt, um sogenannte EEPROMs (EEPROM = electrically erasable programmable read-only memory = elektrisch löschbarer programmierbarer Nur-Lese-Speicher) zu programmieren und/oder zu löschen.

Zur Programmierung von EEPROM-Schaltungen ist zumindest eine hohe Spannung einer Polarität, vorzugsweise positiver Polarität, notwendig. Eine EEPROM-Zelle besteht im wesentlichen aus einem MOS-Feldeffekttransistor (MOSFET = Metall-Oxid-Semiconductor-Feldeffekttransistor), zumeist vom n-Typ, dessen Gate-Anschluss von allen übrigen Elementen des MOS-Transistors elektrisch isoliert ist, wobei in diesem Zusammenhang von einem "Floating-Gate"-Bereich gesprochen wird. Über dem Floating-Gate-Bereich befindet sich ein sogenannter Steuer-Gate-Anschluss (control gate). Zum Programmieren der EEPROM-Zelle wird nun eine hohe Spannung als Potentialdifferenz zwischen den Steuer-Gate-Anschluss und dessen Drain- oder Source-Anschlussbereich oder dessen Kanal-Bereich angelegt, wobei diese Bereiche im folgenden allgemein zusammengefasst als DSC-Bereich bezeichnet werden. Durch die extrem hohe elektrische Feldstärke zwischen dem DSC-Bereich und dem Floating-Gate-Bereich durchtunneln Ladungsträger die dazwischenliegende dünne isolierende Schicht, wobei dieser Tunnelvorgang als Fowler-Nordheim-Effekt bezeichnet wird. Wird die Programmierspannung anschließend abgeschaltet, so sind auf dem Floating-Gate-Bereich Ladungsträger gefangen, die die Einsatzspannung des MOS-Transistors beeinflussen.

Zur Veranschaulichung kann man beispielsweise eine n-Typ-MOS-Transistorzelle nennen, deren Einsatzspannung im Ausgangszustand z. B. bei 0,65 V liegt, d. h. der Transistor ist ursprünglich selbstsperrend (Enhancement-Typ). Wird nun für die Dauer von einigen Millisekunden eine Spannung von beispielsweise +20 V an den Steuer-Gate-Anschluss angelegt, wobei der DSC-Bereich auf einer Spannung von 0 V liegt, wird eine Verschiebung der Einsatzspannung der Transistorzelle beispielsweise auf etwa 7 V zu beobachten sein.

Zum Löschen von EEPROM-Zellen gibt es nun im wesentlichen zwei Vorgehensweisen. Bei der ersten Vorgehensweise wird an den DSC-Bereich eine positive Spannung von +20 V angelegt, während an dem Steuer-Gate-Anschluss eine Spannung von 0 V anliegt. Die zweite Vorgehensweise besteht darin, dass an den Steuer-Gate-Anschluss eine negative Spannung von -20 V angelegt wird, während der DSC-Bereich auf einer Spannung von 0 V gehalten wird.

Es gibt Anhaltspunkte dafür, dass die zweitgenannte Vorgehensweise eine erhöhte Zuverlässigkeit und Reproduzierbarkeit des Löschvorgangs einer EEPROM-Zelle bewirkt, wie dies beispielsweise in der US-Patentschrift 5,255,237 beschrieben wird.

Darüber hinaus ist diese Vorgehensweise zum Löschen der EEPROM-Zelle insofern vorteilhaft, als die mit dem DSC-Bereich des Transistors verbundenen Schaltungselemente sowohl für den Programmiervorgang als auch für den Löschvorgang nur relativ niedrige Spannungen aushalten müssen. Dadurch wird aufgrund vereinfachter Schaltungsentwürfe bei dieser Variante kostbare Chipfläche eingespart. Bei dieser Vorgehensweise kann das Löschen der oben erwähnten n-Typ-MOS-Transistorzelle beispielsweise derart erfolgen, dass man an den Steuer-Gate-Anschluss für die Dauer von einigen Millisekunden eine Spannung von -20 V anlegt, während der DSC-Bereich dabei auf einer Spannung von 0 V gehalten wird. Danach ist die Einsatzspannung der Transistorzelle auf eine Spannung von etwa -6 V gesunken, wobei dies bedeutet, dass der Transistor nunmehr selbstleitend ist (Depletion-Typ).

Es ist zu beachten, dass sowohl beim Programmieren als auch beim Löschen einer EEPROM-Zelle gemäß der oben geschilderten Vorgehensweise kein nennenswerter Strom fließt. Man kann nun davon ausgehen, dass der Strom, der aufgrund des Fowler-Nordheim-Effekts fließt, d. h. der durch das Durchtunneln der dünnen isolierenden Schicht hervorgerufen wird, kleiner als die unvermeidlichen Leckströme ist, die über die gesperrten pn-Übergänge der beteiligten Bauelemente gegen das Substrat abfließen. Insbesondere bedeutet dies für eine Ladungspumpe, die die Programmierspannung und die Löschspannung einer EEPROM-Zelle zur Verfügung stellen soll, dass diese nur einen geringen Strom zu liefern braucht, der typischerweise nur wenige Mikroampere beträgt.

Es zeigt sich also als vorteilhaft, zum Programmieren und Löschen einer EEPROM-Zelle eine bipolare Ladungspumpe einzusetzen, da diese abhängig von dem gewählten Betriebszustand entweder die hohe positive oder die hohe negative Programmierspannung und die entsprechende Löschspannung mit entgegengesetzter Polarität zur Verfügung stellen kann.

Bei dem praktischen Aufbau einer bipolaren Ladungspumpe als Bestandteil eines integrierten Schaltkreises (IC), d.h. insbesondere bei der Realisierung der mit der bipolaren Ladungspumpe verbundenen Schalteranordnungen, die die jeweilige Programmier- bzw. Löschspannung an dem Steuer-Gate-Anschluss der EEPROM-Zelle bereitstellen sollen, treten jedoch eine Reihe von gravierenden schaltungstechnischen Problemen auf.

Integrierte Schaltkreise (ICs) arbeiten üblicherweise mit einer relativ niedrigen Betriebsspannung V_{DD}, die beispielsweise zwischen einer Spannung von 3 V bis 8 V liegen kann. Daher werden die technologischen. Parameter des integrierten Schaltkreises auf diese kleinen Spannungen optimiert, das heißt insbesondere, dass alle verwendeten Standardbauelemente nur mit Spannungen von maximal der Betriebsspannung V_{DD}, die also beispielsweise bei 4 V liegt, beaufschlagt werden dürfen.

Werden nun beispielsweise an pn-Übergänge, wie z. B. an einen Bulk-Substrat-Übergang eines als Schalter eingesetzten MOS-Transistors, zu große Sperrspannungen angelegt, so brechen diese aufgrund der hohen Feldstärke durch und werden niederohmig. Sofern dabei keine Thyristorstruktur zündet (Latchup-Effekt) und keine unzulässige Verlustleistung umgesetzt wird, führt dieser Durchbruch zumindest zu keiner bleibenden Schädigung der Halbleiterstruktur des MOSFET.

Will man nun Ladungspumpen für wesentlich höhere Spannungen als die maximale Durchbruchspannung einer gewählten Halbleitertechnologie aufbauen, so verwendet man derzeit im wesentlichen speziell angepasste Hochvolt-Bauelemente (HV-Bauelemente), deren Durchbruchspannungen durch geänderte Dotierungsverhältnisse oder Dielektrika ausreichend hoch ausgelegt sind. Diese Anpassungen stellen für den Schaltungstechniker beim reinen Schaltungsentwurf keine großen Probleme dar, die technische Realisierung und Herstellung solcher speziell angepassten Hochvolt-Bauelemente ist jedoch äußerst aufwendig und kostspielig, denn derartige speziell angepasste HV-Bauelemente erfordern bei deren Herstellung zusätzliche Maskenebenen und Prozessschritte, wodurch der Fertigungsaufwand und damit die Fertigungskosten erheblich ansteigen. Zudem erfordern derartige spezielle Bauelemente einen erhöhten Platzbedarf, da höhere Spannungen nur auf größeren Distanzen mit einem niedrigeren Feld abgebaut werden können, was ebenfalls zu einer Erhöhung der Herstellungskosten führt. Ferner wird durch den erhöhten Platzbedarf kostbare Chipfläche verbraucht, was eine optimale Miniaturisierung der integrierten Schaltkreise verhindert.

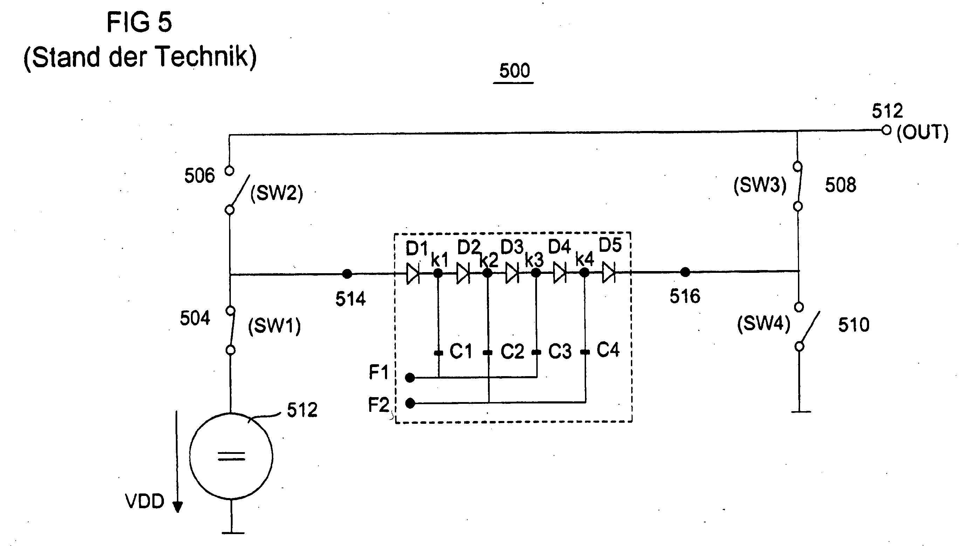

In Fig. 5 ist nun eine bipolare Ladungspumpenanordnung 500 einschließlich einer vierstufigen bipolaren Ladungspumpe 502 zur Erzeugung positiver und negativer Spannungen und deren Schalteranordnung 504 - 510 aus vier Schaltern SW1 - SW4 zum Durchschalten der jeweiligen hohen positiven oder hohen negativen Ladungspumpenspannung an einen Ausgangsport 512 (OUT) dargestellt.

Die bipolare Ladungspumpe 502, wie sie in Fig. 5 dargestellt ist, besteht im wesentlichen aus einer Serienschaltung von Dioden, vorzugsweise MOS-Dioden, wobei als MOS-Diode ein MOS-Transistor bezeichnet wird, dessen Gate-Anschluss und dessen Drain-Anschluss miteinander verschaltet sind, so dass der MOS-Transistor daher nur in einer Richtung leitend ist, in der anderen Richtung jedoch sperrt. n-Typ-MOS-Dioden leiten, sofern an dem Gate- und Drain-Anschluss ein Potential anliegt, das um mindestens die Einsatzspannung Vₜₕ der Diode, d. h. des MOS-Transistors, höher ist als jenes Potential an dem Source-Anschluss.

In Analogie zu einer pn-Diode wird im folgenden bei n-Typ-MOS-Dioden von dem gemeinsamen Gate- und Drain-Anschluss als Anodenanschluss und von dem Source-Anschluss als Kathodenanschluss gesprochen. Die Serienschaltung der n-Typ-MOS-Dioden ist so ausgeführt, dass der Anodenanschluss der zweiten Diode D2 mit dem Kathodenanschluss der ersten Diode D1 verbunden ist, der Anodenanschluss der dritten Diode D3 mit dem Kathodenanschluss der zweiten Diode D2 verbunden ist, usw. Die gesamte Serienschaltung der n-Typ-MOS-Dioden D1 - D5 besitzt also an ihrem ersten Ende einen äußeren Anodenanschluss 514 und an ihrem zweiten Ende einen äußeren Kathodenanschluss 516. Jene Netzknoten, an denen die Anodenanschlüsse und Kathodenanschlüsse der einzelnen Dioden zusammengeschaltet sind, werden im folgenden als sogenannte innere Knoten der Ladungspumpe 502 bezeichnet und sind von k1 bis k4 durchnumeriert.

Eine n-stufige Ladungspumpe besteht also aus (n+1)-Dioden und n Pumpkapazitäten C₁ - C₄, deren eine Elektrode an dem jeweiligen inneren Knoten k1 - k4 der Ladungspumpe geschaltet ist. Die zweiten Elektroden jeder Pumpkapazität, die an ungerade innere Knoten geschaltet sind, werden miteinander verbunden und an eine gemeinsame Taktleitung mit dem Taktsignal F1 gelegt, wobei die zweiten Elektroden der geradzahligen Pumpkapazitäten C₂, C₄ ebenfalls zusammengeschaltet werden und an die Taktleitung mit dem Taktsignal F2, die den Komplementärtakt zu dem Taktsignal F1 aufweist, gelegt sind. Die Taktsignale F1, F2 sind hochfrequente Rechtecksignale mit einer Frequenz von ca. 10 MHz, und einem Betriebszyklus (duty cycle) von ca. 50%, und weisen einen unteren Pegel (Low-Pegel) mit einer Spannung von idealerweise 0 V, sowie einem hohen Pegel (High-Pegel) mit idealerweise der Versorgungsspannung V_{DD} des Bausteins auf.

Als Versorgungsspannung V_{DD} wird nun im folgenden eine Spannung von beispielsweise 4 V angenommen. Wenn das Taktsignal F1 von einem Spannungspegel von 0 V auf einen Spannungspegel von 4 V sprunghaft übergeht, so werden durch die ungeradzahligen. Pumpkapazitäten C₁, C₃, die beispielsweise eine Kapazität von 10 pF aufweisen, die ungeradzahligen inneren Knoten k1, k3.der Ladungspumpe auf ein hohes Potential gezwungen. Zugleich geht das Taktsignal F2 von dem Spannungspegel 4 V auf den Spannungspegel 0 V herunter, so dass über die geradzahligen Pumpkapazitäten C₂, C₄ die geradzahligen Knoten k2, k4 der Ladungspumpe auf einen niedrigen Pegel heruntergezwungen werden. Dadurch werden jene n-Typ-MOS-Dioden D2, D4, deren Anodenanschluss an einem ungeradzahligen inneren Knoten k1, k3 anliegt, in Flussrichtung gepolt, wobei ein Strom von deren Anodenanschluss zu deren Kathodenanschluss zu fließen beginnt, so dass die ungeradzahligen Pumpkapazitäten C₁, C₃ die geradzahligen Pumpkapazitäten C₂, C₄ laden. Anschließend geht das Taktsignal F1 von einem hohen Spannungspegel 4 V auf den niedrigen Spannungspegel 0 V über, wobei das Taktsignal F2 von einem niedrigen Spannungspegel 0 V auf einen hohen Spannungspegel 4 V übergeht, wodurch jene Dioden D3, D5 deren Anodenanschluss an die geradzahligen internen Knoten k2, k4 geschaltet sind, in Flussrichtung gepolt werden, und die geradzahligen Pumpkapazitäten jeweils die darauffolgenden ungeradzahligen Pumpkapazitäten lädt.

Die Funktionsweise einer Ladungspumpe lässt sich also so zusammenfassen, dass wechselweise immer jede zweite n-Typ-MOS-Diode leitet, und die auf den Pumpkapazitäten gespeicherten Ladungen pro Taktflanke des Taktsignals F1, F2 um ca. eine Betriebsspannung V_{DD} (etwa 4 V) minus einer MOS-Einsatzspannung Vₜₕ (etwa 1 V) höheres Potential (etwa 3 V) bringt.

Bei der Ladungspumpenschaltung 502 von Fig. 5 ist ferner zu beachten, dass die Pumpkapazitäten C₁-C₄ eine Entkopplung des Gleichspannungspotential zwischen den inneren Knoten k1-k4 der Ladungspumpe 502 an den ersten Elektroden der Pumpkapazitäten C1-C4 und den Takttreiberschaltungen für die Taktsignale F1, F2 an den zweiten Elektroden der Pumpkapazitäten C₁-C₄ bewerkstelligen. Legt man also die Potentiale für die Taktsignale F1, F2 auf 0 V bzw. 4 V fest, so können die inneren Knoten k1-k4 der Ladungspumpe sowohl auf einer höheren als auch einer niedrigeren Spannung liegen, d. h. also sowohl ein positives als auch ein negatives Vorzeichen ihres Potentials haben. Welches Potential sich einstellt, hängt von den Randbedingungen der Ladungspumpe ab.

Legt man beispielsweise den äußeren Kathodenanschluss 516 der Ladungspumpe 502 an eine Spannung von 0 V, so pumpt sich der äußere Anodenanschluss 514 der Ladungspumpe nach einer gewissen Einschalt- bzw. Einschwingzeitdauer (start-up time) auf ein negatives Potential V_{neg} auf. Legt man nun den äußeren Anodenanschluss 514 der Ladungspumpe an eine Spannung von 0 V, so pumpt sich der äußere Kathodenanschluss 516 der Ladungspumpe schließlich auf ein hohes positives Potential Vₚₒₛ auf.

In der Praxis legt man zur Erzeugung einer positiven Spannung den äußeren Anodenanschluss 514 der Ladungspumpe bereits auf die positive Betriebsspannung V_{DD}, wie dies in Fig. 5 gezeigt ist, so dass man eine Stufe der Ladungspumpe einsparen kann.

Will man mit der in Fig. 5 gezeigten Vorgehensweise mit der bipolaren Ladungspumpe 502 hohe negative bzw. hohe positive Ausgangsspannungen von beispielsweise +/-20 V erzeugen, so müssen die Pumpkapazitäten eine Durchbruchspannung von ca. 20 V aufweisen. Nimmt man nun beispielsweise an, dass eine hohe positive Spannung Vₚₒₛ erzeugt werden soll, so wird die erste Pumpkapazität C₁ auf ein Potential von 3 V (= V_{DD} - Vₜₕ = 4 V - 1 V) aufgeladen. Diese Pumpkapazität C₁ lädt nun die zweite Pumpkapazität C₂ auf ein Potential von 6 V (= 3 V + V_{DD} - Vₜₕ) auf. Dieser Vorgang setzt sich nun fort, so dass die m-te Kapazität auf ein Potential von m*(V_{DD} - Vₜₕ) aufgeladen wird. Die letzte Pumpkapazität wird also auf ein Potential von zumindest 17 V (=Vₚₒₛ - V_{DD} + Vₜₕ) aufgeladen.

Es ist zu beachten, dass diese Verhältnisse nur in jenem Fall gelten, dass der Ladungspumpe kein Strom entnommen wird, d. h. dass die Last der Ladungspumpe sehr hochohmig, z. B. rein kapazitiv, ist. Falls die Ladungspumpe einen nennenswerten Strom liefern muss, so bricht die Spannung an den einzelnen Pumpkapazitäten gemäß der Entnahme an Laststrom periodisch ein, so dass zur Erzielung einer Ausgangsspannung von 20 V die letzte Pumpkapazität im vorliegenden Fall auf eine entsprechend höhere Spannung als 17 V aufgeladen werden muss. Man sieht also, dass die Pumpkapazitäten C₁ - C₄ gegen den jeweiligen Ausgang der Ladungspumpe hin zunehmend mit einer hohen positiven bzw. negativen Spannung belastet werden.

Ein Hauptproblem, das bei dem Aufbau einer bipolaren Ladungspumpenanordnung auftritt, liegt nun darin, elektronische Schalter aufzubauen, die bei dem jeweiligen Betriebszustand der bipolaren Ladungspumpe 502 das richtige Ende der bipolaren Ladungspumpe 502, d. h. den äußeren Anodenknoten 514 bzw. den äußeren Kathodenknoten 516, an einen einzigen Ausgangsport 512 durchschalten, so dass dort an dem Ausgangsport wahlweise die hohe positive bzw. die hohe negative Ausgangsspannung der bipolaren Ladungspumpe 502 zur Verfügung steht. Wie in Fig. 5 dargestellt ist, werden dazu elektronische Schalter SW1 - SW4, denen die Bezugszeichen 504-510 zugewiesen sind, verwendet.

Wie beispielsweise aus der US-Patentschrift 6,023,188 bekannt ist, werden dazu an jedes Ende, d. h. an den externen Anodenknoten 514 und den externen Kathodenknoten 516, der bipolaren Ladungspumpe 502 zwei Hochvolttransistoren (SW1, SW2) 504, 506 und (SW3, SW4) 508, 510 geschaltet, so dass an dem externen Anodenknoten 514 der bipolaren Ladungspumpe 502 die zwei Hochvolttransistoren (SW1, SW2) 504, 506 und dem externen Kathodenknoten 516 der bipolaren Ladungspumpe die zwei Hochvolttransistoren (SW3, SW4) 508, 510 geschaltet sind.

Wenn nun die bipolare Ladungspumpe 502 eine hohe positive Ausgangsspannung erzeugen soll, so wird der Hochvolt-Transistor (HV-Transistor) 504, der den äußeren Anodenknoten 514 der bipolaren Ladungspumpe 502 an eine Betriebsspannungsversorgung (V_{DD}) 512 legt, eingeschaltet, d. h. der Schalter SW1 504 ist eingeschaltet (SW1 on), während der zweite HV-Transistor 506 (SW2), der zwischen dem äußeren Anodenknoten der bipolaren Ladungspumpe und dem Ausgangsport 512 (OUT) der Ladungspumpenanordnung 500 liegt, ausgeschaltet ist (SW2 off). Ferner wird an dem äußeren Kathodenanschluss der bipolaren Ladungspumpe 502 der HV-Transistor 508 (SW3), der den äußeren Kathodenanschluss der bipolaren Ladungspumpe 502 mit dem Ausgangsport 512 verbindet, eingeschaltet (SW3 on), wobei der vierte HV-Transistor 510 (SW4), der sich zwischen dem äußeren Kathodenanschluss der bipolaren Ladungspumpe 502 und Massepotential 0 V befindet, ausgeschaltet ist (SW4 off).

Für den Fall nun, dass die bipolare Ladungspumpe 502 eine hohe negative Ausgangsspannung erzeugen soll, werden diejenigen Transistoren 504, 508 (SW1, SW3), die im Fall einer hohen positiven Ausgangsspannung der bipolaren Ladungspumpe 502 leitend waren, ausgeschaltet, wobei ferner diejenigen HV-Transistoren 506, 510 (SW2, SW4), die im Fall einer hohen positiven Ausgangsspannung der bipolaren Ladungspumpe 502 sperrend waren, eingeschaltet werden.

Diese "relativ einfache" prinzipielle Funktionsbeschreibung des Durchschaltens der hohen negativen bzw. hohen positiven Ausgangsspannung der bipolaren Ladungspumpenanordnung 500, wie es in Fig. 5 dargestellt ist, an einen einzigen Ausgangsport 512, ist in der Praxis jedoch äußerst aufwendig zu realisieren, da bezogen auf integrierte Schaltkreise äußerst hohe positive und negative Spannungen von den elektronischen Schaltern, d. h. den HV-Transistoren 504-510 (SW1 - SW4) durchzuschalten oder zu sperren sind, um an dem einen Ausgangsport (OUT) 512 der bipolaren Ladungspumpenanordnung 500 die gewünschte hohe negative bzw. hohe positive Ausgangsspannung bereitzustellen.

In diesem Zusammenhang sollte beachtet werden, dass in der US-Patentschrift 6,023,188 spezielle Hochvolt-Transistoren als elektronische Schalter verwendet werden. Diese Hochvolt-Transistoren sind durch spezielle, sehr aufwendige Veränderungen ihres Aufbaus geeignet angepasst worden, um ausreichend hohen Spannungen standzuhalten, d. h. diese hohen Spannungen durchzuschalten oder zu sperren. Der spezielle Aufbau solcher HV-Transistoren erfordert bei deren Herstellung jedoch zusätzliche Prozessschritte.

Dabei ist insbesondere zu beachten, dass es verschiedene Vorgehensweisen gibt, einen Feldeffekttransistor in einem bestimmten Maße hochspannungstauglich zu machen.

Es ist beispielsweise vergleichsweise einfach und kostengünstig eine hohe Durchbruchspannung zwischen dem Bulk-Bereich und dem Substrat-Bereich eines Feldeffekttransistors zu erzielen.

Bereits einen erhöhten Aufwand kostet es, eine hohe Durchbruchspannung auch noch zwischen dem Drain- und Gate-Bereich sowie zwischen dem Drain- und dem Source-Bereich eines Feldeffekttransistors zu erzielen. Dazu wird beispielsweise bei einem MOSFET der Gate-Anschluss in Richtung des Source-Anschlusses verschoben, um die Feldstärke im Drain/Gate-Übergangsbereich niedrig zu halten.

Bezüglich bekannter Vorgehensweisen, um einen Feldeffekttransistor in einem bestimmten Maße hochspannungstauglich zu machen, wird auf die Fachliteraturquelle mit dem Titel "High voltage devices and circuits in standard CMOS technologies" von Hussein Ballan und Michelle Declerq, erschienen bei Kluwer Academic Publishers, verwiesen. ,

Den größten herstellungstechnischen Aufwand kostet es jedoch, die Gate/Source-Durchbruchspannung zwischen dem Gate- und dem Source-Anschluss eines Feldeffekttransistors zu erhöhen, da dazu das Gate-Oxid des Feldeffekttransistors verändert werden muss, wohingegen bei den beiden vorher genannten Vorgehensweisen zur Erhöhung der jeweiligen Durchbruchspannungen zumeist nur das Layout des Feldeffekttransistors verändert werden muss.

Der Oberbegriff des unabhängigen Anspruchs ist aus US-Patentschrift 6,023,188 bekannt.

Die bisher im Stand der Technik verwendeten Hochvolt-Transistoren, wie sie beispielsweise in der oben bereits angesprochenen US-Patentschrift 6,023,188 Verwendung finden, müssen jedoch die hohe positive bzw. hohe negative Ausgangsspannung einer bipolaren Ladungspumpe, wie sie beispielsweise prinzipiell in Fig. 5 dargestellt ist, zwischen deren Gate- und Source-Anschluss aushalten, was, wie oben bereits ausge-führt wurde, eine besonders schwierig und aufwendig zu realisierende Anforderung darstellt.

Ausgehend von diesem Stand der Technik besteht die Aufgabe der vorliegenden Erfindung darin, eine verbesserte elektronische Schalteranordnung zum Schalten eines Signals an einem Ausgang einer elektronischen Schaltung, insbesondere einer bipolaren Ladungspumpe, zu schaffen, deren Anforderungen an die Hochspannungstauglichkeit der verwendeten Halbleiterbauelemente, insbesondere der verwendeten Feldeffekttransistoren, reduziert sind.

Diese Aufgabe wird durch eine elektronische Schalteranordnung zum Schalten eines Signals an einem Ausgang einer elektronischen Schaltung gemäß Anspruch 1 gelöst.

Die erfindungsgemäße elektronische Schalteranordnung zum Durchschalten eines Signals an einem ersten Ausgang einer elektronischen Schaltung an einen Gesamtausgang der elektronischen Schalteranordnung umfasst eine Spannungsteileranordnung und einen elektrischen Schalter, z. B. einen Feldeffekttransistor. Die Spannungsteileranordnung umfasst dabei zumindest zwei Impedanzelemente, wobei die Spannungsteileranordnung einen ersten Spannungsteileranschluss, einen zweiten Spannungsteileranschluss und einen Spannungsteilerabgriff aufweist, wobei der erste Spannungsteileranschluss mit dem ersten Ausgang der elektronischen Schaltung verbunden ist, und der zweite Spannungsteileranschluss mit einem Bezugspotential verbunden ist. Der elektronische Schalter umfasst einen ersten Schalteranschluss, einen zweiten Schalteranschluss und einen Steuereingang, wobei der erste Schalteranschluss mit dem ersten Ausgang der elektronischen Schaltung und dem ersten Spannungsteileranschluss verbunden ist, und der zweite Schalteranschluss mit einem zweiten Ausgang der elektronischen Schaltung verbunden ist, und der Steuereingang des elektronischen Schalters mit dem Spannungsteilerabgriff verbunden ist.

Bei einem ersten Betriebszustand weist nun das Signal an dem ersten Ausgang der elektronischen Schaltung einen ersten Spannungspegel auf, der betragsmäßig größer als eine Referenzspannung der elektronischen Schaltung ist, und bei einem zweiten Betriebszustand der elektronischen Schaltung weist das Signal an dem ersten Ausgang derselben einen zweiten Spannungspegel auf, der betragsmäßig kleiner oder gleich der Referenzspannung ist, wenn die elektronische Schaltung beispielsweise ein Ladungspumpe ist, wie es für bestimmte Anwendungen bevorzugt ist.

Die Impedanzelemente des Spannungsteilers sind nun derart dimensioniert, dass an dem Spannungsteilerabgriff des ersten Spannungsteilers dem Steuereingang des elektronischen Schalters eine Steuerspannung bereitgestellt wird, so dass der elektronische Schalter bei dem ersten Betriebszustand der elektronischen Schaltung das Signal an dem ersten Ausgang der elektronischen Schaltung von dem ersten Schalteranschluss des elektronischen Schalters an den Gesamtausgang der elektronischen Schalteranordnung durchschaltet, und der elektronische Schalter bei dem zweiten Betriebszustand der elektronischen Schaltung das Signal an dem ersten Ausgang der elektronischen Schaltung von dem Gesamtausgang der elektronischen Schalteranordnung trennt.

Der vorliegenden Erfindung liegt nun die Erkenntnis zugrunde, eine elektronische Schalteranordnung, die zum Schalten eines Ausgangssignals einer elektronischen Schaltung, wie z. B. zum Schalten einer hohen negativen bzw. einer hohen positiven Ausgangsspannung einer bipolaren Ladungspumpe, vorgesehen ist, aus einem elektronischen Schalter, z. B. einem FET-Schalter, und einer zugeordneten Spannungsteileranordnung derart aufzubauen, so dass die an dem Spannungsteilerabgriff anliegende Spannung, die dem elektronischen Schalter an dessen Steuereingang, d. h. an den Gate-Anschluss eines MOSFET, als Steuerspannung zugeführt wird, bei beiden Betriebszuständen der elektronischen Schaltung so dimensioniert ist, dass der elektronische Schalter entsprechend dem Betriebszustand entweder das Ausgangssignal der elektronischen Schaltung sicher an den Gesamtausgang durchschaltet oder sicher von demselben sperrt, wobei darüber hinaus bei jedem Betriebszustand der elektronischen Schaltung, d. h. vorzugsweise einer bipolaren Ladungspumpe sichergestellt ist, dass die Differenzspannung zwischen dem Steueranschluss und dem ersten Schalteranschluss, d. h. bei einem FET-Schalter die Gate-Source-Spannung des verwendeten FET, eine vorbestimmte Referenzspannung nicht übersteigt, wobei die Referenzspannung vorzugsweise der Betriebsspannung V_{DD} der Schaltungsanordnung entspricht.

Durch eine derartige Anordnung lassen sich spannungsfeste elektronische FET-Schalter zur Auskopplung beispielsweise der erzeugten hohen negativen bzw. hohen positiven Pumpspannung einer bipolaren Ladungspumpe an einem einzigen Ausgangsport mittels geringfügig modifizierter Standard-Feldeffekttransistoren realisieren, die beispielsweise in einer Standard-Triple-Well-CMOS-Technologie ausgeführt sind.

Wenn beispielsweise als die elektronische Schaltung eine bipolare Ladungspumpe eingesetzt wird, weist bei dem ersten Betriebszustand das Signal an dem zweiten Ausgang der elektronischen Schaltung einen dritten Spannungspegel auf, der betragsmäßig kleiner oder gleich der Referenzspannung ist, wobei das Signal bei dem zweiten Betriebszustand an dem zweiten Ausgang der elektronischen Schaltung einen vierten Spannungspegel aufweist, der betragsmäßig größer als die Referenzspannung ist.

Geht man nun davon aus, dass die elektronische Schaltung an ihrem ersten Ausgang in dem ersten Betriebszustand eine hohe negative Spannung V_{neg}, von z. B. -20 V, erzeugt, und an dem zweiten Ausgang eine niedrige Spannung, beispielsweise 0 V, anliegt, und in dem zweiten Betriebszustand der elektronischen Schaltung an deren erstem Ausgang eine niedrige Spannung, beispielsweise zwischen 0 V und der Betriebsspannung V_{DD}, anliegt, und an ihrem zweiten Ausgang eine hohe positive Spannung Vₚₒₛ, beispielsweise +20 V, erzeugt wird, wird für den elektronischen Schalter ein n-Typ-Feldeffekttransistor verwendet.

Wird die elektronische Schaltung beispielsweise nun derart betrieben, dass bei dem zweiten Betriebszustand der elektronischen Schaltung das hohe positive Ausgangssignal derselben beispielsweise mittels eines weiteren Schalters an den Gesamtausgang der elektronischen Schalteranordnung angelegt wird, so liegt an dem Gate-Anschluss des n-Typ-MOSFETs aufgrund des Spannungsteilers nach Masse ein niedrigeres Potential (0V bis V_{DD}) als an dessen Source-Anschluss an. Daher sperrt der n-Typ-MOSFET. Somit ist die niedrige Spannung an dem ersten Ausgang der elektronischen Schaltung von dem Gesamtausgang der elektronischen Schalteranordnung und damit beispielsweise von der hohen positiven Spannung an dem zweiten Ausgang der elektronischen Schaltung sicher getrennt.

Die mit dem ersten Ausgang der elektronischen Schaltung verbundene Spannungsteileranordnung kann nun so dimensioniert werden, um die Belastung für den n-Typ-MOSFET zu begrenzen, d. h. insbesondere die Gate-Source-Spannung V_{GS} (die Spannung zwischen dem Gate- und dem Source-Anschluss des Feldeffekttransistors) auf dessen maximal vorgesehenen Wert unterhalb der Gate/Source-Durchbruchspannung zu beschränken.

Geht man nun davon aus, dass die elektronische Schaltung an ihrem ersten Ausgang bei dem ersten Betriebszustand eine hohe positive Spannung, z. B. +20 V, und an ihrem zweiten Ausgang eine niedrige Spannung, z. B. 0 V, bereitstellt, und bei dem zweiten Betriebszustand an dem ersten Ausgang der elektronischen Schaltung eine relativ niedrige Spannung, die z. B. zwischen 0 V und der Betriebsspannung V_{DD} liegt und an dem zweiten Ausgang eine hohe negative Spannung, z. B. -20 V bereitgestellt wird. Soll nun in dem ersten Betriebszustand der elektronische Schalter das hohe positive Ausgangssignal des ersten Ausgangs der elektronischen Schaltung an den Gesamtausgang der elektronischen Schalteranordnung durchschalten, wobei der zweite Ausgang beispielsweise mittels eines weiteren Schalters von dem Gesamtausgang getrennt ist, und der elektronische Schalter in dem zweiten Betriebszustand das niedrige Potential an dem ersten Schalterausgang von dem Gesamtausgang der elektronischen Schalteranordnung und damit beispielsweise von der hohen negativen Ausgangsspannung an dem zweiten Ausgang der elektronischen Schaltung, die beispielsweise mittels des weiteren Schalters an den Gesamtausgang durchgeschaltet wird, trennen, so wird in diesem Fall für den elektronischen Schalter an dem ersten Ausgang einer elektronischen Schaltung ein p-Typ-MOSFET verwendet.

Die Realisierung der elektronischen Schalteranordnung zum Schalten eines Signals an dem ersten Ausgang der elektronischen Schaltung unter Verwendung eines p-Typ-MOSFET erfolgt dabei im wesentlichen entsprechend zu der Vorgehensweise bezüglich eines n-Typ-MOSFET.

Aus den obigen Ausführungen wird deutlich, dass es für den n-Typ- bzw. p-Typ-MOSFET, der als elektronischer Schalter bei der vorliegenden Erfindung eingesetzt werden soll, noch erforderlich ist, eine hohe Durchbruchspannung zwischen dem Bulk-Bereich und dem Substrat vorzusehen. Ferner ist es erforderlich, eine hohe Durchbruchspannung zwischen dem Drain- und dem Gate-Bereich sowie zwischen dem Drain- und dem Source-Bereich des MOSFETs zu erzielen. Diese Modifizierungen an dem MOSFET können jedoch im wesentlichen durch relativ einfache und unaufwendige Layout-Änderungen angepasst werden.

Eine Layout-Änderung bedeutet dabei nur einen gewissen Aufwand in der CAD-Umgebung (CAD = computer aided design = computerunterstützter Entwurf) bei der IC-Entwicklung, nicht jedoch bei der Wafer-Prozessierung. Insbesondere werden keine zusätzlichen Prozessierungsschritte und somit keine zusätzlichen Masken bei der Herstellung der integrierten Schaltkreise erforderlich, so dass die Herstellungskosten derartig aufgebauter integrierter Schaltkreise gegenüber Standardprozessen im wesentlichen gleich bleiben.

Der Hauptvorteil der vorliegenden Erfindung besteht nun darin, dass die Durchbruchspannung zwischen dem Gate- und Source-Bereich eines Feldeffekttransistors durch die erfindungsgemäße elektronische Schalteranordnung nicht überschritten wird, d. h. bei der vorliegenden Erfindung kann die Steuerspannung, die an dem Gate-Anschluss des als Schalter wirksamen Feldeffekttransistors anliegt, so eingestellt werden, dass die Durchbruchspannung zwischen dem Gate- und dem Source-Bereich des MOSFET nicht überschritten wird. Daher ist es bei der vorliegenden Erfindung nicht erforderlich, speziell angepasste Hochvolt-Feldeffekttransistoren zu verwenden, bei denen das Gate-Oxid prozesstechnisch aufwendig verändert werden muss, d. h. bei denen sehr aufwendige zusätzliche Prozessierungsschritte bei der Herstellung des integrierten Schaltkreises erforderlich sind.

Laut dem Stand der Technik müssten dagegen die als Schalter wirksamen Feldeffekttransistoren eine Gate-Source-Durchbruchspannung aufweisen, die der hohen negativen bzw. hohen positiven Ausgangsspannung der elektronischen Schaltung, z. B. einer bipolaren Ladungspumpe, gleichkommt. Das bedeutet jedoch zumeist, dass diese Feldeffekttransistoren ein dickeres Gate-Oxid benötigen, als es für Standardtransistoren vorgesehen ist, wie sie beispielsweise bei der vorliegenden Erfindung im wesentlichen eingesetzt werden können.

Es wird also deutlich, dass bei den Feldeffekttransistoren, die bei der vorliegenden Erfindung als elektronische Schalter eingesetzt werden, bei deren Herstellung keine zusätzliche Hochvolt-Gate-Oxid-Maske erforderlich ist, und somit zusätzliche Prozessschritte bei der Herstellung des integrierten Schaltkreises vermieden werden können, so dass sich der Herstellungsaufwand und damit die Herstellungskosten eines integrierten Schaltkreises unter Verwendung der elektronischen Schalteranordnung gemäß der vorliegenden Erfindung im wesentlichen nicht erhöhen, da bei der vorliegenden Erfindung für die Feldeffekttransistoren das standardmäßige Niedervolt-Gate-Oxid eingesetzt werden kann.

Um die prozesstechnischen Anforderungen bei der Herstellung eines integrierten Schaltkreises, der die erfindungsgemäße elektronische Schalteranordnung umfasst, weiter zu vereinfachen, d. h. um die Anforderung an einen n-Typ-MOSFET, der entsprechend den obigen Ausführungen eine hohe Drain-seitige Durchbruchspannung und gleichzeitig einen isolierten p-Bulkbereich aufweist, zu verringern, wird bei einem weiteren Ausführungsbeispiel der vorliegenden Erfindung eine Kaskode aus n-Typ-MOS-Feldeffekttransistoren in Triple-Well-Technologie als elektronischer Schalter verwendet.

Bei dieser Weiterentwicklung wird der als elektronischer Schalter wirksame n-Typ-Feldeffekttransistor durch mehrere (z. B. zwei, drei, ...) in Serie geschaltete Standard-Niedervolt-n-Typ-MOSFETs ersetzt, von denen jeder einzelne einen isolierten Bulk-Bereich besitzt. Außerdem sind die Durchbruchspannungen am Drain/Source- zu Bulk-Bereich sowie an dem Bulk-Bereich zu dem Substrat durch die oben bereits erwähnten Layout-Maßnahmen auf die maximale Ausgangsspannung der elektronischen Schaltung, d. h. beispielsweise auf die hohe negative Ausgangsspannung V_{neg} und die hohe positive Ausgangsspannung Vₚₒₛ einer bipolaren Ladungspumpe, erhöht. Die Anforderungen an die Gate-Kanal-Durchbruchsicherheit sowie an die Drain-Source-Durchbruchsicherheit brauchen jedoch lediglich jenen von Standard-NV-n-Typ-MOSFETs (NV = Niedervolt) entsprechen, wobei die Durchbruchspannungen üblicherweise in der Größenordnung der Betriebsspannung V_{DD} der elektronischen Schaltung liegen.

Bei dieser elektronischen Schalteranordnung gemäß einer weiteren vorteilhaften Ausführungsform der vorliegenden Erfindung werden die Steuereingänge, d. h. die Gate-Anschlüsse von beispielsweise drei NV-n-Typ-MOSFETs so angesteuert, dass diese MOSFETs die hohe negative Spannung V_{neg} an dem ersten Ausgang der elektronischen Schaltung durchlassen.

Andererseits sperrt die Kaskodenschaltung der NV-n-Typ-MOSFETs die an dem zweiten Schalteranschluss anliegende hohe positive Spannung Vₚₒₛ bei dem zweiten Betriebszustand der elektronische Schaltung sicher, indem in diesem Fall die Gate-Anschlüsse, d. h. die Steuereingänge, der drei NV-n-Typ-MOSFETs ein unterschiedlich abgestuftes Potential erhalten. Damit kann eine beispielsweise drei-stufige NV-n-Typ-MOSFET-Kaskode eine maximale Spannung (positive Ausgangsspanung der Ladungspumpe) von etwa dem vierfachen Wert der Betriebsspannung (Vₚₒₛ = V_{DD} + 3 * V_{GS-max} ≈ 4 * V_{DD}) sicher sperren.

Will man noch größere Spannung sperren, so kann die Kaskode nach dem gleichen Schema erweitert werden. Besteht also die NV-n-Typ-MOSFET-Kaskode aus n Transistoren, so werden die Gate-Anschlüsse der FETs im Falle einer hohen positiven Ausgangsspannung an dem Gesamtausgang, die beispielsweise mittels eines weiteren Schalters von dem zweiten Ausgang der elektronischen Schaltung an den Gesamtausgang durchgeschaltet werden, mit einer entsprechend abgestuften Steuerspannung (V_{DD} + (m-1) * V_{GS-max}) angesteuert, so dass Spannungen von bis zu dem (n+1)-fachen Wert der maximalen Gate-Source-Spannung V_{GS-max} durch die Kaskodenschaltung von dem ersten Anschluss der elektronischen Schaltung, d. h. beispielsweise von dem äußeren Anodenanschluss einer bipolaren Ladungspumpe, isoliert werden können.

Die abgestuften Steuerspannungen für die Steuereingänge, d. h. Gate-Anschlüsse der n-Typ-MOSFET der Kaskodenschaltung, werden beispielsweise an einem modifizierten Spannungsteiler gewonnen, der eine entsprechend erhöhte Anzahl von Impedanzelementen aufweist, wobei die Anzahl der nun vorhandenen Spannungsteilerabgriffe beispielsweise der Anzahl der Steuereingänge des elektronischen Schalters, d. h. der Anzahl der Gate-Anschlüsse der MOSFETs, entspricht. Dazu wird der modifizierte Spannungsteiler entsprechend den bereits oben ausgeführten Dimensionierungsregeln aufgebaut.

Es ist zu beachten, dass durch den Spannungsteiler in beiden Betriebszuständen der elektronischen Schaltung die maximale Gate-Source-Durchbruchspannung an den einzelnen n-Typ-MOSFETs der Kaskodenschaltung durch die geeignete Dimensionierung der einzelnen Impedanzelemente des Spannungsteilers nicht überschritten wird. Dadurch ergibt sich eine starke Vereinfachung bei der prozesstechnischen Realisierung und Herstellung eines integrierten Schaltkreises (IC) unter Verwendung der erfindungsgemäßen elektronischen Schalteranordnung.

Um die NV-n-Typ-MOSFETs der Kaskodenschaltung sowohl bei einer hohen positiven als auch bei einer hohen negativen Ausgangsspannung der elektronischen Schaltung, d. h. sowohl bei dem ersten als auch zweiten Betriebszustand der elektronischen Schaltung, vom Substrat zu isolieren, werden diese Transistoren in einer sogenannten Triple-Well-Technologie aufgebaut. Alle NV-n-Typ-MOSFETs der Kaskodenschaltung können dabei in einer gemeinsamen äußeren n-Wanne liegen.

Um den pn-Übergang zwischen dem p-Bulk-Bereich und der n-Wanne mit möglichst kleinen Spannungen zu belasten, empfiehlt es sich bei der vorliegenden Erfindung, die n-Wanne an den zweiten Ausgang der elektronischen Schaltung, z. B. an den äußeren Kathodenanschluss einer bipolaren Ladungspumpe, zu legen. Wie bereits erörtert, kann durch die geeignete Wahl der Impedanzelemente des verwendeten Spannungsteilers die Gate-Source-Spannung an dem jeweiligen MOSFET, der zum Schalten des Ausgangssignals der elektronischen Schaltung vorgesehen ist, so gering gehalten werden, dass das Gate-Oxid dieses MOSFETs nicht überlastet wird.

Somit ist im Falle eines einzigen Feldeffekttransistors als elektronischer Schalter ein MOSFET ausreichend, der lediglich zwischen seinem Drain- und Gate-Bereich und zwischen seinem Drain-/Source-Bereich und dem Substrat die volle hohe positive Ausgangsspannung Vₚₒₛ aushalten muss.

Wird außerdem die erörterte Kaskodenschaltung aus einer Mehrzahl von n-Typ-MOSFETs verwendet, brauchen lediglich die Durchbruchspannungen zwischen dem Drain-/Source-Bereich und dem Bulk-Bereich sowie zwischen dem Bulk-Bereich und dem Substrat durch Layout-Maßnahmen auf die maximale positive bzw. negative Ausgangsspannung der Ladungspumpe Vₚₒₛ bzw. V_{neg} erhöht werden. Die Auslegung bezüglich des Gate-Kanal-Durchbruchs sowie des Drain-Source-Durchbruchs kann dabei jedoch wie bei Standard-NV-n-Typ-MOSFETs, d. h. beispielsweise etwa gleich der Betriebsspannung V_{DD} der elektronischen Schaltung, gewählt werden.

Ferner ist zu beachten, dass das geschilderte Prinzip der Kaskodenschaltung auf noch höhere positive bzw. negative Spannungen erweitert werden kann, indem lediglich weitere NVn-Typ-MOSFETs in der Kaskodenschaltung in Serie geschaltet werden und nach dem gezeigten Prinzip angesteuert werden.

Durch die erfindungsgemäße elektronische Schalteranordnung wird daher ermöglicht, dass lediglich durch leicht beherrschbare Layoutänderungen der integrierten Schaltkreise, ohne dass Prozessänderungen, wie z. B. zusätzliche Prozessschritte, bei der Herstellung derselben erforderlich sind, die erfindungsgemäße elektronische Schalteranordnung mit jeglichen elektronischen Schaltungen auf einem Halbleiterchip integriert werden können.

Bevorzugte Ausführungsbeispiele der vorliegenden Erfindung werden nachfolgend Bezug nehmend auf die beiliegenden Zeichnungen näher erläutert. Es zeigen:
- Fig. 1: den prinzipiellen Aufbau einer elektronischen Schalteranordnung gemäß einem ersten Ausführungsbeispiel der vorliegenden Erfindung;
- Fig. 2: eine technische Realisierung einer elektronischen Schalteranordnung gemäß dem ersten Ausführungsbeispiel der vorliegenden Erfindung;
- Fig. 3: den prinzipiellen Aufbau einer elektronischen Schalteranordnung gemäß einem zweiten Ausführungsbeispiel der vorliegenden Erfindung;
- Fig. 4: eine technische Realisierung einer elektronischen Schalteranordnung gemäß dem zweiten Ausführungsbeispiel der vorliegenden Erfindung;
- Fig. 5: den Aufbau einer herkömmlichen Schalteranordnung für eine mehrstufige bipolare Ladungspumpe gemäß dem Stand der Technik;
- Fig. 6a-b: prinzipielle Darstellungen eines n-Typ- und p-Typ-MOSFET mit einem Aufbau in Triple-Well-Technologie.

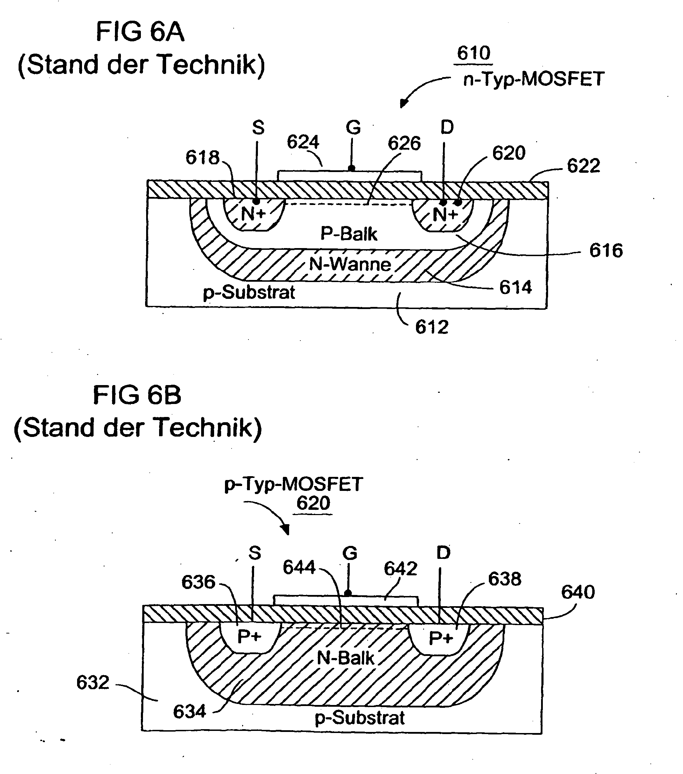

Zur Vereinfachung der folgenden detaillierten Erörterung der verschiedenen Ausführungsbeispiele der erfindungsgemäßen elektronischen Schalteranordnung werden im folgenden bezugnehmend auf Fig. 6a und 6b die zum Verständnis erforderlichen Begriffe bezüglich des Aufbaus eines n-Typ-MOSFET, vgl. Fig. 6a, und eines p-Typ-MOSFETs, vgl. Fig. 6b, in Triple-Well-Technologie kurz dargestellt.

Fig. 6a zeigt den Aufbau eines n-Typ-MOSFET 610 in Triple-Well-Technologie. Der n-Typ-MOSFET 610 ist auf einem p-Typ-Substrat 612 gebildet. Der n-Typ-MOSFET 610 weist n-Typ-Wanne 614 auf, in der sich der p-Typ-Bulk-Bereich 616 befindet. In dem p-Typ-Bulk-Bereich 616 befinden sich der n-Typ-Source-Anschluß 618 und der n-Typ-Drain-Anschluß 620. Über einer dünnen Oxid-Schicht 622 befindet sich der Gate-Anschluß 624. Zwischen dem n-Typ-Source-Anschluß 618 und dem n-Typ-Drain-Anschluß 620 befindet sich ein Kanalbereich 626.

Fig. 6b zeigt den Aufbau eines p-Typ-MOSFETs 630 in Triple-Well-Technologie. Der p-Typ-MOSFET 630 ist auf einem p-Typ-Substrat 632 gebildet. Der p-Typ-MOSFET 630 weist einen n-Typ-Bulk-Bereich 634 (auch n-Typ-Wanne genannt) auf. In dem n-Typ-Bulk-Bereich 634 befinden sich der p-Typ-Source-Anschluß 636 und der p-Typ-Drain-Anschluß 638. Über einer dünnen Oxid-Schicht 640 befindet sich der Gate-Anschluß 642. Zwischen dem p-Typ-Source-Anschluß 636 und dem p-Typ-Drain-Anschluß 638 befindet sich ein Kanalbereich 644.

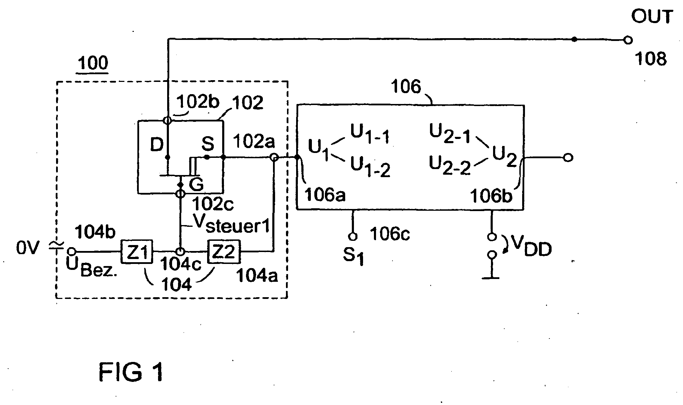

Im folgenden wird nun Bezug nehmend auf Fig. 1 der prinzipielle Aufbau einer elektronischen Schalteranordnung gemäß einem ersten bevorzugten Ausführungsbeispiel der vorliegenden Erfindung detailliert erörtert.

Wie in Fig. 1 dargestellt ist, umfasst die elektronische Schalteranordnung 100 einen elektronischen Schalter 102 und eine Spannungsteileranordnung 104. Der elektronische Schalter 102 umfasst einen ersten Schalteranschluss 102a, einen zweiten Schalteranschluss 102b und einen Steuereingang 102c. Der erste Schalteranschluss 102a ist mit einem ersten Ausgang 106a einer elektronischen Schaltung 106 verbunden. Die elektronische Schaltung 106 umfasst ferner einen zweiten Ausgang 106b. Der zweite Schalteranschluss 102b ist mit einem Gesamtausgang 108 (Ausgangsport OUT) der elektronischen Schalteranordnung 100 verbunden.

Die Spannungsteileranordnung 104 umfasst ein erstes Impedanzelement 21 und ein zweites Impedanzelement Z2, wobei die Spannungsteileranordnung 104 einen ersten Spannungsteileranschluss 104a, einen zweiten Spannungsteileranschluss 104b und einen Spannungsteilerabgriff 104c aufweist. Der erste Spannungsteileranschluss 104a ist mit dem ersten Ausgang 106a der elektronischen Schaltung 106 und damit mit dem ersten Schalteranschluss 102a des elektronischen Schalters 102 verbunden. Der zweite Spannungsteileranschluss 104b ist mit einem Bezugspotential U_{bez} verbunden, das vorzugsweise auf Massepotential (0 V) liegt. Der Spannungsteilerabgriff 104c ist mit dem Steuereingang 102c des elektronischen Schalters 102 verbunden.

Die elektronische Schaltung 106 weist optional einen Eingang 106c auf, an den ein Betriebszustandssignal S₁ angelegt werden kann, um einen ersten oder einen zweiten Betriebszustand der elektronischen Schaltung 106 extern einzustellen. Die elektronische Schaltung 106 ist ferner vorzugsweise mit einer Referenzspannung V_{DD} verbunden, die beispielsweise die Betriebs- oder Versorgungsspannung der elektronischen Schaltung 106 darstellt.

Bei dem ersten Betriebszustand der elektronischen Schaltung 106 weist das Signal U₁ an dem ersten Ausgang 106a der elektronischen Schaltung 106 einen ersten Spannungspegel U₁₋₁ auf, der betragsmäßig größer als die Referenzspannung V_{DD} ist. Bei dem zweiten Betriebszustand der elektronischen Schaltung 106 weist das Signal U₁ an dem ersten Ausgang 106a der elektronischen Schaltung 106 einen zweiten Spannungspegel U₁₋₂ auf, der betragsmäßig kleiner oder gleich der Referenzspannung V_{DD} ist.

Bei dem ersten Betriebszustand weist ferner das Signal U₂ an dem zweiten Ausgang 106b der elektronischen Schaltung 106 einen dritten Spannungspegel U₂₋₁ auf, der betragsmäßig kleiner oder gleich der Referenzspannung V_{DD} ist, wobei bei dem zweiten Betriebszustand das Signal U₂ an dem zweiten Ausgang 106b der elektronischen Schaltung 106 einen vierten Spannungspegel U₂₋₂ aufweist, der betragsmäßig größer als die Referenzspannung V_{DD} ist, wenn es sich beispielsweise bei der elektronischen Schaltung 106 um eine bipolare Ladungspumpe handelt.

Die Impedanzelemente Z1, Z2 der Spannungsteileranordnung 104 sind nun so dimensioniert, dass an dem Spannungsteilerabgriff 104c der Spannungsteileranordnung 104 dem Steuereingang 102c des elektronischen Schalters 102 eine Steuerspannung Vₛₜₑᵤₑᵣ₁ bereitgestellt wird, so dass der elektronische Schalter 102 bei dem ersten Betriebszustand der elektronischen Schaltung 106 das Signal U₁ an dem ersten Ausgang 106a der elektronischen Schaltung 106 von dem ersten Schalteranschluss 102a des elektronischen Schalters 102 an den zweiten Schalteranschluss 102b desselben und damit an den Gesamtausgang 108 durchschaltet, und der elektronische Schalter 102 bei dem zweiten Betriebszustand der elektronischen Schaltung 106 den ersten Ausgang 106a der elektronischen Schaltung 106 von dem Gesamtausgang 108 der elektronischen Schalteranordnung 100 trennt.

Wie in Fig. 1 dargestellt ist, weist der elektronische Schalter 102 einen Feldeffekttransistor (FET) mit einem Drain-Anschluss, einem Source-Anschluss, einem Gate-Anschluss und einem Bulk-Bereich auf, wobei der Source-Anschluss dem ersten Schalteranschluss 102a, der Drain-Anschluss dem zweiten Schalteranschluss 102b und der Gate-Anschluss dem Steuereingang 102c des elektronischen Schalters 102 zugeordnet ist. Der Bulk-Bereich des FET ist vorzugsweise mit dem Source-Anschluss des FET verbunden. Es ist bei der vorliegenden Erfindung zu beachten, dass der Feldeffekttransistor einen isolierten Bulk-Bereich aufweist. Ein n-Typ-Feldeffekttransistor mit einem isolierten Bulk-Bereich wird beispielsweise realisiert, indem der p-Typ-Bulk-Bereich des n-Typ-Feldeffekttransistors mittels einer n-Typ-Wanne von dem p-Typ-Substrat isoliert wird (vgl. Fig. 6a).

Die Impedanzelemente Z1, Z2 der Spannungsteileranordnung 104 sind ferner so dimensioniert, dass sowohl bei dem ersten als auch bei dem zweiten Betriebszustand der elektronischen Schaltung 106 die Spannungsdifferenz zwischen dem Steuereingang 102c und dem ersten Schalteranschluss 102a des elektronischen Schalters 102, d. h. zwischen dem Gate- und Source-Anschluss eines Feldeffekttransistors, kleiner oder gleich einer maximalen Gate/Source-Spannung ist, wobei diese maximale Gate/Source-Spannung vorzugsweise der Referenzspannung V_{DD} entspricht.

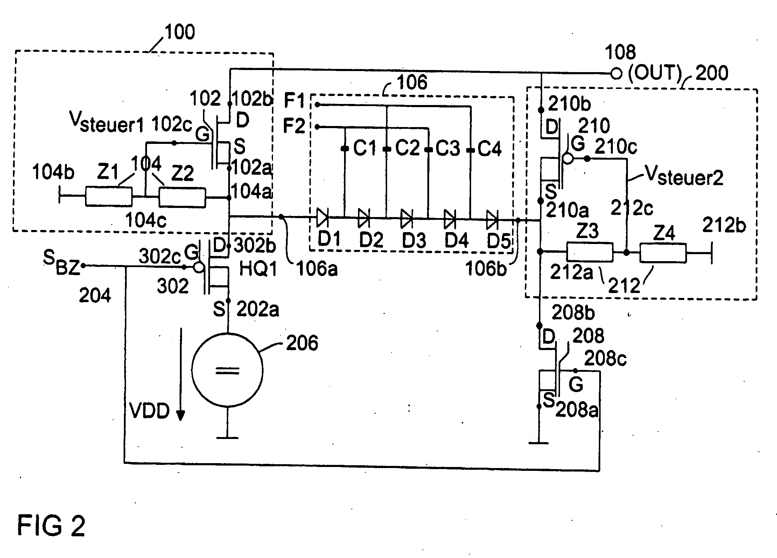

In dem zweiten Zustand der elektronischen Schaltung 106 wird die hohe Ausgangsspannung an dem zweiten Ausgang der elektronischen Schaltung 106b mit einem in Fig. 1 nicht gezeigten weiteren Schalter (vgl. Schalter 200 in Fig. 2) an den Gesamtausgang 108 der elektronischen Schalteranordnung 100 gelegt, so dass im zweiten Betriebszustand auch an dem Drain-Anschluß des Feldeffekttransistors 102 diese hohe Spannung anliegt. Der weitere Schalter (200 in Fig. 2) wird anhand von Fig. 2 detailliert erläutert.

Der Feldeffekttransistor 102 ist nun derart ausgelegt und modifiziert, dass dieser an seinem Drain-Anschluss eine maximal anlegbare Drain-Durchbruchspannung aufweist, die zumindest dem dritten Spannungspegel U₂₋₁ entspricht, so dass der verwendete FET im Falle eines n-Typ-MOSFET eine hohe Durchbruchspannung gegenüber einer hohen positiven Ausgangsspannung, die am zweiten Ausgang 106b der elektronischen Schaltung 106 anliegt, und im Falle eines p-Typ-MOSFET eine hohe Durchbruchspannung an dem Drain-Anschluss 102b gegenüber hohen negativen Spannungen an dem zweiten Ausgang 106b der elektronischen Schaltung 106 aufweist.

Der Feldeffekttransistor weist ferner zwischen seinem Gate- und Source-Anschluss vorzugsweise eine Gate/Source-Durchbruchspannung auf, die lediglich maximal der Referenzspannung V_{DD} entsprechen braucht. Die Impedanzelemente Z1, Z2 der Spannungsteileranordnung 104 sind ferner so dimensioniert, dass an dem Spannungsteilerabgriff 104c ein Spannungspegel der Steuerspannung Vₛₜₑᵤₑᵣ₁ anliegt, so daß die Differenz zwischen V₁ und V_{steuer 1} kleiner oder gleich der Gate/Source-Durchbruchspannung des Feldeffekttransistors ist.

Das Bezugspotential U_{bez}, das an dem zweiten Spannungsteileranschluss 104b anliegt, ist bei diesem Ausführungsbeispiel vorzugsweise Massepotential (0V), und die Referenzspannung V_{DD} ist vorzugsweise die Betriebs- oder Versorgungsspannung der elektronischen Schaltung 106.

Die Impedanzelemente Z1, Z2 der Spannungsteileranordnung 104 sind beispielsweise resistive und/oder kapazitive Schaltungselemente.

Im folgenden wird nun die Funktionsweise der in Fig. 1 dargestellten erfindungsgemäßen Schalteranordnung gemäß dem ersten Ausführungsbeispiel der vorliegenden Erfindung erläutert.

Durch die in Fig. 1 dargestellte Schalteranordnung lassen sich spannungsfeste elektronische FET-Schalter zur Auskopplung beispielsweise der erzeugten hohen positiven bzw. hohen negativen Pumpspannung einer bipolaren Ladungspumpe an einem einzigen Ausgangsport mittels geringfügig modifizierter Standard-Feldeffekttransistoren relativ einfach realisieren, die beispielsweise in einer Standard-Triple-Well-CMOS-Technologie ausgeführt sind.

Geht man nun beispielsweise davon aus, dass die elektronische Schaltung 106 an ihrem ersten Ausgang 106a in dem ersten Betriebszustand eine hohe negative Spannung V_{neg}, von z. B. -20 V, erzeugt, und an dem zweiten Ausgang 106b eine niedrige Spannung, beispielsweise 0 V, anliegt, und in dem zweiten Betriebszustand der elektronischen Schaltung an deren erstem Ausgang 106a eine niedrige Spannung, beispielsweise zwischen 0 V und der Betriebsspannung V_{DD}, anliegt, und an ihrem zweiten Ausgang 106b eine hohe positive Spannung Vₚₒₛ, beispielsweise +20 V, erzeugt wird, wird für den elektronischen Schalter 102 ein n-Typ-Feldeffekttransistor verwendet.

Ferner ist zur Realisierung der elektronischen Schalteranordnung 100 mittels der zwei Impedanzelemente Z1, Z2 an dem ersten Anschluss 106a der elektronischen Schaltung 106, z. B. an dem äußeren Anodenanschluss einer bipolaren Ladungspumpe, der Spannungsteiler 104 nach Masse (0 V) vorgesehen. Der Mittelabgriff 104c des Spannungsteilers 104 ist an den Steuereingang 102c des elektronischen Schalters 100, d. h. an den Gate-Anschluss des n-Typ-Feldeffekttransistors 102, gelegt.

Dadurch ist sichergestellt, dass im Falle hoher negativer Spannungen an dem ersten Ausgang 106a der elektronischen Schaltung 106, d. h. an dem äußeren Anodenanschluss der Ladungspumpe, und somit an dem ersten Schaltereingang 102a, d. h. an dem Source-Anschluss des n-Typ-MOSFETs 102, dessen Gate-Anschluss auf einem höheren Potential als der Source-Anschluss liegt, so dass der n-Typ-MOSFET 102 leitend wird und somit die hohe negative Spannung V_{neg} an dem ersten Ausgang 106a der elektronischen Schaltung, die an dem Source-Anschluss des n-Typ-MOSFET 102 anliegt, an dessen Drain-Anschluss, d. h. an den zweiten Schalteranschluss 106b, durchschaltet.

Wird die elektronische Schaltung 106 nun derart betrieben, dass die elektronische Schaltung 106 in dem zweiten Betriebszustand an dem zweiten Ausgang 106b, z. B. an dem äußeren Kathodenknoten einer bipolaren Ladungspumpe, eine hohe positive Spannung Vₚₒₛ erzeugt, und an dem ersten Ausgang 106a eine relativ niedrige Spannung, beispielsweise zwischen einem Potential von 0 V und der Betriebsspannung V_{DD}, anliegt, liegt aufgrund des Spannungsteilers 104 nach Masse an dem Gate-Anschluss des n-Typ-MOSFETs 102 ein niedrigeres Potential, das beispielsweise zwischen 0V und der Referenzspannung V_{DD} liegt, als an dessen Source-Anschluss an. Daher sperrt der n-Typ-MOSFET 102. Somit ist in dem zweiten Betriebszustand der elektronischen Schaltung 106 die relativ niedrige Spannung an dem ersten Ausgang 106a der elektronischen Schaltung 106 von der hohen positiven Spannung Vₚₒₛ an dem zweiten Ausgang 106b der elektronischen Schaltung 106 sicher getrennt.

Die mit dem ersten Ausgang der elektronischen Schaltung verbundene Spannungsteileranordnung kann nun so dimensioniert werden, um die Belastung für den n-Typ-MOSFET stark zu begrenzen, d. h. insbesondere die Gate-Source-Spannung V_{GS} (die Spannung zwischen dem Gate- und dem Source-Anschluss des Feldeffekttransistors) auf einen Wert unter dessen maximal vorgesehenen Wert, d. h. unter die Gate/Source-Durchbruchspannung, zu beschränken.

Im folgenden wird nun die geeignete Dimensionierung der Impedanzelemente Z1, Z2 der Spannungsteileranordnung 104 erläutert. Wenn nun die Impedanzelemente Z1, Z2 der Spannungsteileranordnung 104 komplexe Impedanzen darstellen, beträgt das Spannungsteilerverhältnis k = Z1/(Z1+Z2). Liegt nun an dem ersten Ausgang 106a der elektronischen Schaltung 106 eine hohe negative Spannung V_{neg} an, so liegt der Gate-Anschluss des n-Typ-MOSFET an einer Spannung von (V_{neg}*k), wobei für seine Gate-Source-Spannung gilt, (V_{GS}(on) = (k-1) * V_{neg}).

Nimmt man nun an, dass diese Spannung zugleich auch der maximal erlaubten Gate-Source-Spannung V_{GS-max} des n-Typ-MOSFETs entsprechen soll, erhält man durch eine entsprechende Umformung folgendes Spannungsteilerverhältnis (k = 1 + V_{GS-max}/V_{neg}).

Als einfaches Zahlenbeispiel wird nun beispielsweise angenommen, dass die hohe negative Spannung V_{neg} an dem ersten Ausgang der Schaltungseinrichtung -20 V beträgt. Wenn jedoch die maximale Gate-Source-Spannung des n-Typ-MOSFET-Schalters maximal einer Spannung von beispielsweise 5 V entspricht, d. h. dass das Gate-Oxid des n-Typ-Feldeffekttransistors keine höhere Gate-Source-Spannung aushält, ergibt sich daraus ein Spannungsteilerverhältnis von k = 15/20 = 0,75.

Somit kann die Spannungsteileranordnung 104 genau so dimensioniert werden, dass mittels der Steuerspannung Vₛₜₑᵤₑᵣ₁ die maximal erlaubte Gate-Source-Spannung V_{GS-max} des n-Typ-MOSFETs nicht überschritten wird.

Geht man nun davon aus, dass die elektronische Schaltung 106 an ihrem ersten Ausgang 106a bei dem ersten Betriebszustand eine hohe positive Spannung Vₚₒₛ, z. B. +20 V, und an ihrem zweiten Ausgang 106b eine niedrige Spannung, z. B. 0 V, bereitstellt, und bei dem zweiten Betriebszustand an dem ersten Ausgang 106a der elektronischen Schaltung 106 eine relativ niedrige Spannung, die zwischen 0 V und der Betriebsspannung V_{DD} liegt, und an dem zweiten Ausgang 106b eine hohe negative Spannung V_{neg}, z. B. -20 V, bereitgestellt wird, wobei in dem ersten Betriebszustand der elektronischen Schalter 102 das hohe positive Ausgangssignal Vₚₒₛ des ersten Ausgangs 106a der elektronischen Schaltung 106 durchschalten soll, und wobei der elektronischen Schalter 106 in dem zweiten Betriebszustand das relativ niedrige Potential an dem ersten Schalterausgang 106a von der hohen negativen Ausgangsspannung V_{neg} an dem zweiten Ausgang 106b der elektronischen Schalteranordnung 106 trennen soll. In diesem Fall wird für den Schalter ein p-Typ-MOSFET verwendet.

In dem zweiten Zustand der elektronischen Schaltung 106 wird also die hohe Ausgangsspannung an dem zweiten Ausgang der elektronischen Schaltung 106b mit einem in Fig. 1 nicht gezeigten weiteren Schalter (vgl. Schalter 200 in Fig. 2) an den Gesamtausgang 108 der elektronischen Schalteranordnung 100 gelegt, so dass im zweiten Betriebszustand auch an dem Drain-Anschluß des Feldeffekttransistors 102 diese hohe Spannung anliegt. Der weitere Schalter (200 in Fig. 2) wird anhand von Fig. 2 detailliert erläutert.

Die Realisierung der elektronischen Schalteranordnung 100 zum Schalten eines Signals U1 an dem ersten Ausgang 106a der elektronischen Schaltung 106 erfolgt dabei im wesentlichen entsprechend zu der oben bezüglich eines n-Typ-MOSFET erörterten Vorgehensweise. Mittels der zumindest zwei Impedanzelemente Z1, Z2 wird nun an dem ersten Ausgang der elektronischen Schaltung 106, in diesem beispielsweise dem äußeren Kathodenanschluss einer bipolaren Ladungspumpe, wiederum ein Spannungsteiler 104 nach Masse gebildet. Der Mittelabgriff des Spannungsteilers wird wiederum an den Steuereingang 102c, d. h. den Gate-Anschluss des p-Typ-MOSFET des elektronischen Schalters 102 angelegt, wodurch sichergestellt ist, dass im Falle hoher positiver Spannungen Vₚₒₛ an dem ersten Ausgang 106a der elektronischen Schaltung 106 das Gate-Potential des p-Typ-MOSFET 102 unter sein Source-Potential sinkt, so dass der p-Typ-MOSFET 102 leitend ist. Wird nun das Spannungsteilerverhältnis mit (k'= Z1/(Z2+Z1)) bezeichnet, so soll wiederum gelten (k'= 1+V_{GS-max}/Vₚₒₛ).

Liegt nun bei dem zweiten Betriebszustand an dem ersten Ausgang 106a der elektronischen Schaltung 106 eine Spannung von beispielsweise 0 V an, wird das Potential an dem Steueranschluss 102c des elektronischen Schalters 102, d. h. die Spannung an dem Gate-Anschluss des p-Typ-MOSFETs 102 auf Masse gezogen, so dass der p-Typ-MOSFET 102 ausgeschaltet ist, und der erste Ausgang 106a der elektronischen Schaltungsanordnung 106 von dem zweiten Ausgang 106b der elektronischen Schaltung 106, an dem die hohe negative Spannung V_{neg} anliegt, sicher getrennt ist.

Aus den obigen Ausführungen wird deutlich, dass es für den n-Typ- bzw. p-Typ-MOSFET, der als elektronischer Schalter 102 bei der vorliegenden Erfindung eingesetzt werden soll, einerseits erforderlich ist, eine hohe Durchbruchspannung zwischen dem Bulk-Bereich und dem Substrat vorzusehen. Ferner ist es erforderlich, eine hohe Durchbruchspannung zwischen dem Drain- und dem Gate-Bereich sowie zwischen dem Drain- und dem Source-Bereich des MOSFETs zu erzielen. Diese Modifizierungen an dem MOSFET können im wesentlichen durch relativ einfache und unaufwendige Layout-Änderungen angepasst werden. Eine Layout-Änderung bedeutet dabei nur einen gewissen Aufwand in der CAD-Umgebung bei der IC-Entwicklung, nicht jedoch bei der Wafer-Prozessierung. Insbesondere werden keine zusätzlichen Prozessierungsschritte und somit keine zusätzlichen Masken bei der Herstellung der integrierten Schaltkreise erforderlich, so dass die Herstellungskosten derartig aufgebauter integrierter Schaltkreise gegenüber Standardprozessen im wesentlichen gleich bleiben.

Der Hauptvorteil der vorliegenden Erfindung besteht nun darin, dass die Durchbruchspannung zwischen dem Gate- und Source-Bereich eines Feldeffekttransistors durch die erfindungsgemäße elektronischen Schalteranordnung nicht überschritten wird, d. h. bei der vorliegenden Erfindung kann die Steuerspannung, die an dem Gate-Anschluss des als Schalter wirksamen Feldeffekttransistors anliegt, so eingestellt werden, dass die Gate/Source-Durchbruchspannung zwischen dem Gate- und dem Source-Bereich des MOSFET nicht überschritten wird. Daher ist es bei der vorliegenden Erfindung nicht erforderlich, spezielle Hochvolt-Feldeffekttransistoren zu verwenden, bei denen das Gate-Oxid prozesstechnisch aufwendig verändert werden muss, d. h. bei denen aufwendige zusätzliche Prozessierungsschritte bei der Herstellung des integrierten Schaltkreises erforderlich sind.

Laut dem Stand der Technik müssten dagegen die als Schalter wirksamen Feldeffekttransistoren eine Gate-Source-Durchbruchspannung aufweisen, die der hohen negativen bzw. hohen positiven Ausgangsspannung der elektronischen Schaltung, z. B. einer bipolaren Ladungspumpe, gleichkommt. Das bedeutet jedoch zumeist, dass diese Feldeffekttransistoren ein dickeres Gate-Oxid benötigen, als es für Standardtransistoren, wie sie beispielsweise bei der vorliegenden Erfindung im wesentlichen eingesetzt werden können, vorgesehen ist.

Es wird also deutlich, dass bei den Feldeffekttransistoren, die bei der vorliegenden Erfindung als elektronische Schalter eingesetzt werden, bei deren Herstellung keine zusätzliche Hochvolt-Gate-Oxid-Maske erforderlich ist, und somit zusätzliche Prozessschritte bei der Herstellung des integrierten Schaltkreises vermieden werden können, so dass sich der Herstellungsaufwand und damit die Herstellungskosten eines integrierten Schaltkreises unter Verwendung der elektronischen Schalteranordnung gemäß der vorliegenden Erfindung im wesentlichen nicht erhöhen, da bei der vorliegenden Erfindung für die Feldeffekttransistoren das standardmäßige Niedervolt-Gate-Oxid eingesetzt werden kann.

Im folgenden wird nun Bezug nehmend auf Fig. 2 eine praktische Realisierung der Schalteranordnung gemäß dem ersten Ausführungsbeispiel der vorliegenden Erfindung detailliert dargestellt.

Wie bereits erörtert, ist die elektronischen Schaltung 106 vorzugsweise eine Ladungspumpe, deren Funktionsweise in der Beschreibungseinleitung bereits ausführlich erörtert wurde, wobei der erste Ausgang 106a der elektronischen Schaltung 106 den äußeren Anodenknoten der bipolaren Ladungspumpe 106 darstellt, und der zweite Ausgang 106b der elektronischen Schaltung 106 den Kathodenknoten der bipolaren Ladungspumpe darstellt.

Wie in der Beschreibungseinleitung zum Stand der Technik anhand von Fig. 5 bereits erläutert wurde, ist zum Durchschalten der jeweiligen hohen positiven oder hohen negativen Ladungspumpenspannung einer bipolaren Ladungspumpe an einen Ausgangsport nun eine Schalteranordnung erforderlich, die im wesentlichen aus vier elektronischen FET-Schaltern besteht. Dabei sind bei der vorliegenden Erfindung diejenigen FET-Schalter von besonderem Interesse, die die hohe negative oder die hohe positive Ausgangsspannung der bipolaren Ladungspumpe an den einen Ausgangsport durchschalten sollen, da diese elektronischen Schalter entsprechend dem Betriebszustand der bipolaren Ladungspumpe die hohen negative Ausgangsspannung bzw. die hohe positive Ausgangsspannung der bipolaren Ladungspumpe durchlassen bzw. sperren müssen, so dass an diese elektronischen Schalter, die als FET-Schalter ausgeführt sind, die höchsten schaltungstechnischen Anforderungen gestellt sind.

Diese elektronischen Schalter werden daher bei der in Fig. 2 dargestellten praktischen Realisierung unter Verwendung der in Fig. 1 erörterten elektronischen Schalteranordnungen gemäß dem ersten Ausführungsbeispiel der vorliegenden Erfindung realisiert.

Die elektronische Schalteranordnung von Fig. 2 umfasst dabei vier FET-Schalter 100, 200, 202 und 208, wobei der FET-Schalter 100 prinzipiell die Schaltfunktion der Schalteranordnung SW2 von Fig. 5, der FET-Schalter 200 prinzipiell die Schaltfunktion der Schalteranordnung SW3 von Fig. 5, der FET-Schalter 202 prinzipiell die Schaltfunktion der Schalteranordnung SW1 von Fig. 5 und der FET-Schalter 208 prinzipiell die Schaltfunktion der Schalteranordnung SW4 von Fig. 5 übernimmt.

Der elektronische Schalter 100 von Fig. 2 weist eine erste Spannungsteileranordnung 104 aus zwei Impedanzelementen Z1, Z2 auf, wobei die erste Spannungsteileranordnung 104 einen ersten Spannungsteileranschluss 104a, einen zweiten Spannungsteileranschluss 104b und einen Spannungsteilerabgriff 104c aufweist. Der erste Spannungsteileranschluss 104a ist mit dem ersten Anschluss 106a der elektronischen Schaltung 106 verbunden. Der zweite Spannungsteileranschluss 104b ist mit dem Referenzpotential verbunden, das in diesem Fall Massepotential (0V) ist.

Der elektronische Schalter 100 weist ferner einen FET 102 auf, der als ein n-Typ-MOS-Feldeffekttransistor ausgeführt ist. Der Gate-Anschluss (Steuereingang) 102c des Feldeffekttransistors 102 ist mit dem Spannungsteilerabgriff 104c verbunden. Der erste Schalteranschluss 102a, d. h. der Source-Anschluss des Feldeffekttransistors 102 ist mit dem ersten Anschluss 104a des Spannungsteilers 104 und damit mit dem ersten Anschluss 106a der elektronischen Schaltung 106 verbunden.

In Fig. 2 ist ferner der elektronische Schalter 202, der als p-Typ-MOS-Feldeffekttransistor realisiert ist, dargestellt. Der erste Anschluss 202a des p-Typ-MOSFET 202 ist mit einer Versorgungsspannung V_{DD} (Betriebsspannung) verbunden. Der zweite Anschluss 202b des FET 202 ist mit dem ersten Anschluss 106a der elektronischen Schaltung 106 verbunden. Der Steuereingang (Gate-Anschluss) 202c des FET 202 ist mit einem Signaleingang 204 für das Betriebszustandssignal S_{BZ} verbunden. An dem Signaleingang 204 wird das Signal angelegt, um den Betriebszustand, d. h. den ersten bzw. zweiten Betriebszustand, der elektronischen Schaltung 106 extern vorgeben zu können.

In Fig. 2 ist ferner der elektronische Schalter 208, der als n-Typ-MOS-Feldeffekttransistor realisiert ist, dargestellt. Der n-Typ-MOSFET 208 weist einen ersten Anschluss 208a (Drain-Anschluss), einen zweiten Anschluss 208b (Source-Anschluss) und einen dritten Anschluss 208c (Gate-Anschluss) auf. Der Gate-Anschluss 208c des n-Typ-MOSFET 208 ist mit dem Signaleingang 204 verbunden. Der zweite Anschluss 208b des FET 208 ist mit Massepotential verbunden und der Drain-Anschluss 208a desselben ist mit dem zweiten Ausgang 106b (äußerer Kathodenanschluss) der elektronischen Schaltung 106 verbunden.

In Fig. 2 ist ferner der elektronische Schalter 200, der mit einem p-Typ-MOS-Feldeffekttransistor 210 realisiert ist, dargestellt. Der p-Typ-MOS-Feldeffekttransistor 210 weist einen ersten Anschluss (Source-Anschluss) 210a, einen zweiten Anschluss (Drain-Anschluss) 210b und einen Steuereingang (Gate-Anschluss) 210c auf. Der elektronische Schalter 200 weist ferner einen zweiten Spannungsteiler 212 mit zwei Impedanzelemente Z3, Z4 und einem ersten Spannungsteileranschluss 212a, einem zweiten Spannungsteileranschluss 212b, der vorzugsweise mit Massepotential verbunden ist, und einem Spannungsteilerabgriff 212c. Der erste Spannungsteileranschluss 212a ist mit dem zweiten Ausgang 106b der elektronischen Schaltung 106 und mit dem ersten Anschluss (Source-Anschluss) 210a des p-Typ-MOSFET 210 verbunden. Der Mittelabgriff 212c des Spannungsteilers 212 ist mit dem Steuereingang (Gate-Anschluss) 210c verbunden. Der zweite Anschluss 210b (Drain-Anschluss) des p-Typ-MOSFET 210 ist mit dem Ausgangsport 108 verbunden.

Im folgenden wird nun die Funktionsweise der in Fig. 2 dargestellten Schalteranordnung 200 gemäß der vorliegenden Erfindung dargestellt.

Bei der vorliegenden erfindungsgemäßen elektronischen Schalteranordnung von Fig. 2 werden vier elektronische FET-Schalter 100, 200, 202, 208 in Form von MOS-Feldeffekttransistoren, d. h. in Form der n-Typ-MOSFETs 202, 208 und der p-Typ-MOSFETs 202, 210, verwendet, um die hohe positive und die hohe negative Ausgangsspannung der elektronischen Schaltung 106, die vorzugsweise eine bipolare Ladungspumpe ist, an den einzigen Ausgangsport 108 der elektronischen Schalteranordnung von Fig. 2 durchzureichen. Der Begriff bipolare Ladungspumpe bezeichnet dabei eine Ladungspumpe, die abhängig von einem gewählten Betriebszustand entweder eine hohe negative oder eine hohe positive Ausgangsspannung an dem ersten bzw. zweiten Ausgang derselben zur Verfügung stellen kann.

Bei der vorliegenden Erfindung weist die elektronische Schaltung 106 zwei Betriebszustände auf, wobei die elektronische Schaltung 106, d. h. die bipolare Ladungspumpe, bei dem ersten Betriebszustand an dem ersten Anschluss 106a, d. h. an dem äußeren Anodenknoten, eine hohe negative Ausgangsspannung U₁₋₁, beispielsweise -20 V, ausgibt, während an dem zweiten Anschluss 106b (dem äußeren Kathodenknoten) der elektronischen Schaltung 106 (der bipolaren Ladungspumpe) vorzugsweise Massepotential anliegt. Bei dem zweiten Betriebszustand wird an den ersten Anschluss 106a der elektronischen Schaltung 106 vorzugsweise die Betriebsspannung V_{DD} angelegt, wobei an dem zweiten Anschluss 106b der elektronischen Schaltung 106 die hohe positive Ausgangsspannung (z. B. +20 V) bereitgestellt wird.

Dies wird erreicht, indem der FET 202 bei dem ersten Betriebszustand die hohe negative Ausgangsspannung U₁₋₁ der elektronischen Schaltung 106 von der Betriebsspannung V_{DD}, d. h. der Spannungsversorgung 206, isoliert bzw. bei dem zweiten Betriebszustand die Betriebsspannung V_{DD} an den ersten Ausgang 106a, der nunmehr als Eingang fungiert, der elektronischen Schaltung 106 durchschaltet.

Bei der vorliegenden Erfindung wird als FET 202 ein p-Typ-MOSFET verwendet, dessen Gate-Anschluss bei dem ersten Betriebszustand an die Betriebsspannung V_{DD} gelegt wird bzw. bei dem zweiten Betriebszustand an Massepotential (0 V) gelegt wird. Dies wird erreicht, indem an dem Signaleingang 204 das Betriebszustandssignal S_{BZ} bei dem ersten Betriebszustand einen Spannungspegel aufweist, der der Betriebsspannung V_{DD} entspricht, und bei dem zweiten Betriebszustand einen Spannungspegel von 0 V aufweist.

Der n-Typ-Feldeffekttransistor 208, an dessen Gate-Anschluss 208c das Betriebszustandssignal S_{BZ} anliegt, schaltet bei dem ersten Betriebszustand (S_{BZ} = V_{DD}) durch, d. h. legt Massepotential an den zweiten Anschluss 106b der elektronischen Schaltung 106 an, bzw. weist bei dem zweiten Betriebszustand (S_{BZ} = 0 V) einen gesperrten Zustand auf, so dass der n-Typ-MOSFET 208 bei dem zweiten Betriebszustand die hohe positive Ausgangsspannung an dem zweiten Ausgang 106b der elektronischen Schaltung 106 von Massepotential isoliert.

Sowohl bei dem FET 202 als auch dem FET 208 gilt also sicherzustellen, dass sie in ihrem jeweiligen ausgeschalteten Zustand an ihrer High-Seite große Spannungen aushalten müssen, d. h. wenn der FET 202 bei dem ersten Betriebszustand sperrt, so pumpt sich der äußere Anodenknoten 106a der bipolaren Ladungspumpe 106 auf eine hohe negative Spannung auf, sobald an Taktleitungen die komplementären Taktsignale F1, F2 angelegt werden. Also muss der p-Typ-MOSFET an dieser Stelle die hohe negative Spannung sicher sperren können. Dies gelingt, indem man einen Standard-p-Typ-MOSFET durch Layoutmaßnahmen unter Verwendung von Feldoxid so modifiziert, dass er an seinem Drain-Anschluss 202b eine hohe Drain-Durchbruchspannung zeigt.

Bezüglich bekannter Vorgehensweisen, um einen Feldeffekttransistor in einem bestimmten Maße hochspannungstauglich zu machen, wird wieder auf die Fachliteraturquelle mit dem Titel "High voltage devices and circuits in standard CMOS technologies" von Hussein Ballan und Michelle Declerq, erschienen bei Kluwer Academic Publishers, verwiesen

Darüber hinaus muss der p-Typ-MOSFET 202, wie in Fig. 2 dargestellt, ein isolierter p-Typ-MOSFET sein, was heißt, dass man über das Potential seiner n-Wanne (Bulk-Bereich) frei verfügen kann. Wie in Fig. 2 dargestellt, wird die n-Wanne an das Potential V_{DD} (Betriebsspannung) gelegt. Der p-Typ-MOSFET 202 muss ferner noch so aufgebaut sein, dass sich sein Drain-Bereich (vgl. Fig. 6b) vollständig innerhalb der n-Wanne befindet, denn nur dann ist der Drain-Bereich auch bei negativem Potential, d. h. bei einer hohen negativen Ausgangsspannung der elektronischen Schaltung 106, von seinem Substrat (vgl. Fig. 6b) mittels gesperrter pn-Übergänge isoliert.

Wenn nun der n-Typ-MOSFET 208 bei dem zweiten Betriebszustand (Betriebszustandssignal S_{BZ} = V_{DD}) sperrt, so pumpt sich der äußere Kathodenanschluss 106b der bipolaren Ladungspumpe 106 auf ein hohes positives Potential Vₚₒₛ (U₂₋₂). Der n-Typ-MOSFET muss daher lediglich an seinem Drain-Anschluss 208b eine hohe Durchbruchspannung gegen Substrat wie auch gegen den Gate- und den Source-Bereich aufweisen (vgl. Fig. 6a). Der Bulk-Bereich des n-Typ-MOSFET 208 braucht dabei nicht isoliert zu sein, so dass der Bulk-Bereich identisch mit dem Substrat sein kann, wie dies in Fig. 2 dargestellt ist.

Der FET-Schalter 100 und der FET-Schalter 200 werden bei der elektronischen Schalteranordnung von Fig. 2 mit modifizierten Standard-MOSFET-Schaltern 102, 210 implementiert, wobei insbesondere ein Standard-NV-Gate-Oxid (NV = Niedervolt) ausreichend ist, so dass keine neuen Prozessschritte, bzw. eine modifizierte Maske bei der Herstellung einer integrierten Schaltung unter Verwendung der erfindungsgemäßen Schalteranordnung von Fig. 2 erforderlich sind. Für die modifizierten FETs 102, 210 ist lediglich ein isolierter Bulk-Bereich für den p-Typ-MOSFET 210 und den n-Typ-MOSFET 102 erforderlich, da sonst an den jeweiligen Source-Anschlüssen der beiden Feldeffekttransistoren 102, 210, die jeweils mit ihrem Bulk-Bereich verbunden sind, auch das Substrat komplett auf dem hohen negativen bzw. hohen positiven Potential liegen würde.

Zur Realisierung des FET-Schalters 100 von Fig. 2 wird mittels der Impedanzelemente Z1, Z2 an dem äußeren Anodenanschluss 106a der bipolaren Ladungspumpe 106 ein Spannungsteiler 104 nach Masse 106b vorgesehen. Der Spannungsteilerabgriff 104c des Spannungsteilers 104 wird an den Steuereingang (Gate-Anschluss) 102c des n-Typ-Feldeffekttransistors 102 gelegt. Dadurch ist sichergestellt, dass im Falle negativer hoher Spannungen V_{neg} (U₁₋₁ bei dem ersten Betriebszustand) an dem äußeren Anodenanschluss 106a der bipolaren Ladungspumpe 106 und somit an dem Source-Anschluss 104a des n-Typ-MOSFET 102 dessen Gate-Anschluss 102c demgegenüber auf einem höheren Potential liegt, so dass der n-Typ-MOSFET 102 leitend wird, wobei die hohe negative Spannung V_{neg} von dem Source-Anschluss 102a an den Drain-Anschluss 102b und damit an den Ausgangsport 108 durchgeschaltet wird.

Wird die bipolare Ladungspumpe 106 derart betrieben, dass sie eine positive hohe Ausgangsspannung Vₚₒₛ erzeugen soll (U₂₋₂ bei dem zweiten Betriebszustand), so wird das Betriebszustandssignal S_{BZ} auf 0 V geschaltet, so dass der elektronische Schalter 202, d. h. der p-Typ-MOSFET 202, leitend wird, wobei der äußere Anodenanschluss 106a der Ladungspumpe 106 dadurch an die Betriebsspannung V_{DD} gelegt wird. Somit erhält der Gate-Anschluss 102c des n-Typ-MOSFET 102 des elektronischen Schalters 100 ein niedrigeres Potential als dessen Source-Anschluss 102a, so dass der n-Typ-MOSFET 102 sperrt.

Im folgenden wird nun die bevorzugte Dimensionierung des Spannungsteilers 104, d. h. der Impedanzelemente Z1, Z2, erläutert. Bei dem ersten Spannungsteiler 104 ergibt sich ein Spannungsteilerverhältnis k von (k = Z1/(Z1 + Z2)), wobei die Impedanzen Z1, Z2 komplexe Impedanzen darstellen, d. h. dieselben können einfache Ohmsche Widerstände oder auch Reaktanzen von Kondensatoren sein. Liegt nun an dem äußeren Anodenanschluss 106a der bipolaren Ladungspumpe 106 die hohe negative Ausgangsspannung V_{neg} (U₁₋₁ bei dem ersten Betriebszustand), so liegt das Potential an dem Gate-Anschluss 102c des n-Typ-MOSFETs 102 auf einem Wert von (V_{neg} * k), wobei für dessen Gate-Source-Spannung gilt, (V_{gs} (FET 102 = ein) = (k - 1) * V_{neg}). Diese Spannung soll zugleich auch der maximal erlaubten Gate-Source-Spannung (Durchbruchspannung) des n-Typ-MOSFET 102 entsprechen bzw. diese nicht übersteigen. Durch eine geeignete Umformung erhält man also (k = 1 + V_{gs-max}/V_{neg}).

Die Spannungsteileranordnung 104 kann daher genau so dimensioniert werden, dass mittels der an dem Gate-Anschluss 102c eingestellten Steuerspannung die maximal erlaubte Gate-Source-Spannung V_{GS-max} des n-Typ-MOSFETs 102 nicht überschritten wird.

Während der Einschwingzeitdauer (start-up time) der bipolaren Ladungspumpe 106 sinkt nun bei dem ersten Betriebszustand das Potential U₁₋₁ an dem äußeren Anodenanschluß 106a der Ladungspumpe 106 von einem Wert von 0V auf die hohe negative Ausgangsspannung V_{neg} der bipolaren Ladungspumpe 106 ab. Während der ersten Phase dieses Aufstartens ist somit auch die Gate-Source-Spannung des n-Typ-MOSFET 102 nicht ausreichend, um den n-Typ-MOSFET 102 einzuschalten, d. h. leitend zu machen, so dass die Ausgangsspannung OUT an dem Ausgangsport 108 zunächst auf einem Potential von 0 V bleibt, und dann jedoch sprungartig auf die hohe negative Ausgangsspannung V_{neg} (V_{neg} = Vₜₕ/(k - 1)) abzusinken, wobei die Spannung Vₜₕ die Einsatzspannung des n-Typ-MOSFET 102 ist. Aus diesem Grund empfiehlt sich das Spannungsteilerverhältnis k so klein wie möglich auszulegen, was durch die oben erörterte Dimensionierungsregel für die Impedanzelemente Z1, Z2 des Spannungsteilers 104 gewährleistet ist.

Die Realisierung des zweiten FET-Schalters 200 der mit dem p-Typ-MOSFET 210 an dem zweiten Ausgang 106d, d. h. an dem äußeren Kathodenanschluss, der bipolaren Ladungspumpe 106 realisiert ist, erfolgt im wesentlichen entsprechend zu der oben erörterten Vorgehensweise. Mittels der Impedanzelemente Z3, Z4 wird an dem äußeren Kathodenanschluss 106b der bipolaren Ladungspumpe 106 der Spannungsteiler 212 gegen Masse gebildet.

Der Spannungsteilerabgriff 212c ist mit dem Gate-Anschluss (Steuereingang) 210c des n-Typ-MOSFET 210 verbunden, wodurch sichergestellt ist, dass im Falle einer positiven hohen Ausgangsspannung (zweiter Betriebszustand) an dem äußeren Kathodenanschluss 106b der bipolaren Ladungspumpe 106 das Potential an dem Gate-Anschluss 210c des p-Typ-MOSFET 210 unter dessen Source-Potential sinkt, so dass der p-Typ-MOSFET leitend wird. Bezeichnet man das Spannungsteilerverhältnis des Spannungsteilers 212 mit (k' = Z4/(Z3 + Z4)), so gilt entsprechend, dass (k' = 1 - V_{gs,max}/Vₚₒₛ).

In dem ersten Betriebszustand, d. h. wenn das Betriebszustandssignal S_{BZ} dem Potential der Betriebsspannung V_{DD} entspricht, so wird der n-Typ-MOSFET 208 leitend, so dass der äußere Kathodenanschluss 106b der Ladungspumpe auf Masse gelegt ist, so dass der p-Typ-MOSFET 210 sperrt.

Bei der in Fig. 2 dargestellten Schalteranordnung ist insbesondere vorteilhaft, dass die Gate-Source-Durchbruchspannung der MOSFETs 102 und 210 (Schalter 2 und Schalter 3) nicht der negativen bzw. positiven hohen Ausgangsspannung der bipolaren Ladungspumpe 106 entsprechen muss. Daher wird bei den MOSFETs 102 und 210 kein dickeres Gate-Oxid benötigt, wie dies im Stand der Technik erforderlich ist, so dass leicht modifizierte Standardtransistoren vorgesehen werden können. Es ist also nicht erforderlich, zur Realisierung der elektronischen Schalter 100 und 200, die mit den n-Typ-MOSFET 102 und dem p-Typ-MOSFET 210 realisiert sind, eine zusätzliche Hochvolt-Gateoxid-Maske einzuführen und zusätzliche Prozessschritte vorzusehen, so dass durch die erfindungsgemäße elektronischen Schalteranordnung von Fig. 2 im wesentlich nur ein geringer zusätzlicher Herstellungsaufwand bei der Realisierung eines integrierten Schaltkreises unter Verwendung der erfindungsgemäßen elektronischen Schalteranordnung von Fig. 2 auftreten wird.

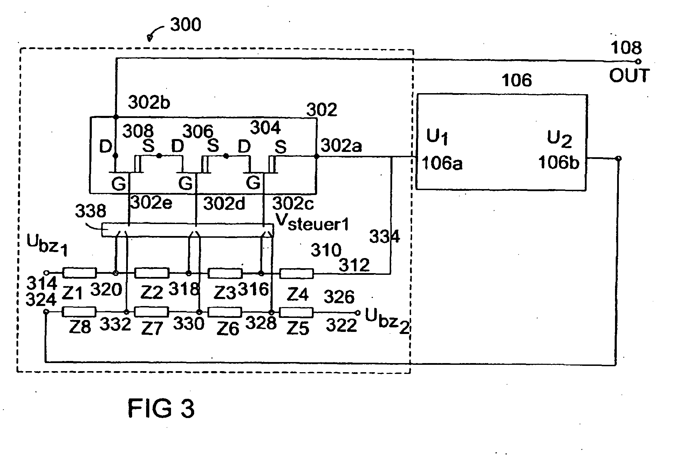

Im folgenden wird nun Bezug nehmend auf Fig. 3 ein weiteres Ausführungsbeispiel einer Schalteranordnung gemäß der vorliegenden Erfindung detailliert erörtert.

Es ist zu beachten, dass Schaltungselemente in der im folgenden anhand von Fig. 3 erörterten elektronischen Schalteranordnung, die mit den in Fig. 1 erörterten Schaltungselementen funktionell übereinstimmen, die gleichen Bezugszeichen aufweisen und nicht nochmals detailliert beschrieben werden.

Die elektronische Schalteranordnung 300 umfasst einen elektronischen Schalter 302, der bei diesem Ausführungsbeispiel drei n-Typ-Feldeffekttransistoren 304, 306, 308 aufweist, wobei die drei Feldeffekttransistoren 304, 306, 308 eine Kaskodenschaltung bilden, wobei der Source-Anschluss des ersten Feldeffekttransistors 304 dem ersten Schalteranschluss 302a zugeordnet ist, und der Drain-Anschluss des dritten Feldeffekttransistors 308 dem zweiten Schalteranschluss 302b zugeordnet ist. Der elektronischen Schalter 302 umfasst ferner drei Steuereingänge 302c, 302d, 302e, wobei jedem Steuereingang der Schalteranordnung 302 der entsprechende Gate-Anschluss der drei Feldeffekttransistoren 304, 306, 308 zugeordnet ist. Ferner umfasst die Schalteranordnung 300 bei diesem Ausführungsbeispiel eine erste Spannungsteileranordnung 310 mit einem ersten Spannungsteileranschluss 312 und einem zweiten Spannungsteileranschluss 314 und vier Impedanzelemente Z1-Z4, zwischen denen drei Spannungsteilerabgriffe 316, 318, 320 gebildet sind.

Die elektronische Schalteranordnung 300 umfasst ferner eine zweite Spannungsteileranordnung 322 mit einem ersten Spannungsteileranschluss 324 und einem zweiten Spannungsteileranschluss 326 und mit vier Impedanzelementen Z5-Z8, zwischen denen drei Spannungsteilerabgriffe 328, 330, 332 gebildet sind.

Der erste Ausgang 106a der elektronischen Schaltung 106 ist mit dem ersten Spannungsteileranschluss 312 des ersten Spannungsteilers 310 verbunden. Ein erstes Bezugspotential U_{bez1} ist mit dem zweiten Spannungsteileranschluss 314 des ersten Spannungsteilers 310 verbunden.

Bei dem ersten Betriebszustand sind die Spannungsteilerabgriffe 316, 318, 320 des ersten Spannungsteilers 310 über eine Umschaltanordnung 338 mit den entsprechenden Steuereingängen 302c, 302d, 302e des elektronischen Schalters 302 verbunden. Die Impedanzelemente Z1-Z4 des ersten Spannungsteilers 310 sind dabei so dimensioniert, dass die Kaskodenschaltung der drei n-Typ-Feldeffekttransistoren 304, 306, 308 während des ersten Betriebszustands der elektronischen Schaltung 106 leitend ist, so dass das Ausgangssignal U1 an dem ersten Ausgang 106a der elektronischen Schaltung 106 zu dem Ausgangsport 108 durchgeschaltet wird.

Der zweite Ausgang 106b der elektronischen Schaltung 106 ist mit dem ersten Spannungsteileranschluss 324 des zweiten Spannungsteilers 322 verbunden, wobei eine zweite Referenzspannung U_{bz2} mit dem zweiten Spannungsteileranschluss 326 des zweiten Spannungsteilers 322 verbunden ist. Die drei Spannungsteilerabgriffe 328, 330, 332 des zweiten Spannungsteilers 322 sind in dem zweiten Betriebszustand über die Umschalteinrichtung 338 mit den entsprechenden Steuereingängen 302c, 302d, 302e des elektronischen Schalters 302, d. h. den Gate-Anschlüssen der n-Typ-Feldeffekttransistoren 304, 306, 308, verbunden.

Die Impedanzelemente Z5-Z8 des zweiten Spannungsteilers 322 sind so dimensioniert, dass die Kaskodenschaltung aus den drei n-Typ-Feldeffekttransistoren 304, 306, 308 bei dem zweiten Betriebszustand sperrt.

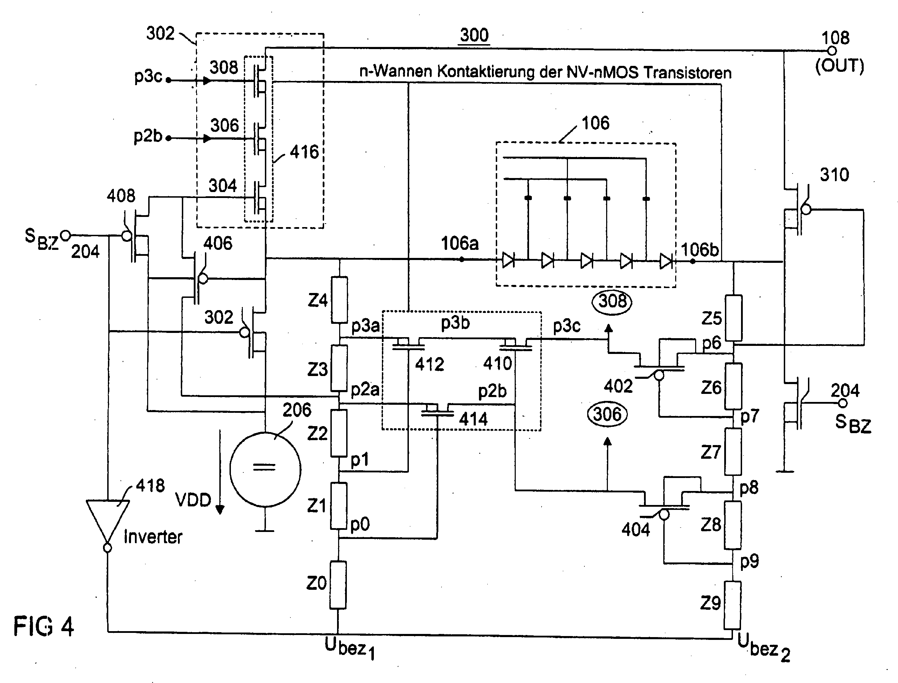

In dem zweiten Zustand der elektronischen Schaltung 106 wird die hohe Ausgangsspannung an dem zweiten Ausgang der elektronische Schaltung 106b mit einem in Fig. 3 nicht gezeigten weiteren Schalter (vgl. Schalter 310 in Fig. 4) an den Gesamtausgang 108 der elektronischen Schalteranordnung 100 gelegt, so dass im zweiten Betriebszustand auch an dem Drain-Anschluß des Feldeffekttransistors 308 diese hohe Spannung anliegt. Der weitere Schalter (310 in Fig. 4) wird anhand von Fig. 4 detailliert erläutert.

Die Impedanzelemente des ersten und zweiten Spannungsteilers 310, 322 sind mittels des ersten Bezugspotentials U_{bz1} und des zweiten Bezugspotential U_{bz2} in dem ersten und zweiten Betriebszustand der Schalteranordnung 302 ferner so dimensioniert, dass die jeweils bei dem ersten und zweiten Betriebszustand anliegende Gate-Source-Spannung an den drei n-Typ-Feldeffekttransistoren 304, 306, 308 eine maximale Gate/Source-Spannung derselben nicht übersteigt, wobei die maximale Gate/Source-Spannung im allgemeinen der Gate-Source-Durchbruchspannung der n-Typ-FETS 304, 306, 308 entspricht.

Bei der vorliegenden Erfindung sind die n-Typ-Feldeffekttransistoren 304, 306, 308 in Triple-Well-Technik (vgl. Fig. 6a) aufgebaut. Dabei sind die n-Typ-Wannen (nicht gezeigt in Fig. 3) der drei Feldeffekttransistoren 304, 306, 308 sowohl bei dem ersten als auch zweiten Betriebszustand der elektronischen Schaltung 106 mit dem zweiten Ausgang 106b der elektronischen Schaltung 106 verbunden.

Bei diesem Ausführungsbeispiel der elektronischen Schalteranordnung 300 gemäß der vorliegenden Erfindung ist die Referenzspannung vorzugsweise die Betriebsspannung V_{DD} der elektronischen Schaltung 106, wobei die maximale Gate-Source-Durchbruchspannung der drei Feldeffekttransistoren 304, 306, 208 vorzugsweise der Betriebsspannung V_{DD} entspricht.

Das erste Bezugspotential U_{bz1} weist bei dem ersten Betriebszustand ein niedriges Potential von vorzugsweise 0V auf, wobei das zweite Bezugspotential U_{bz2} bei dem zweiten Betriebszustand ein Potential aufweist, das vorzugsweise der Betriebsspannung V_{DD} entspricht.

Im folgenden wird nun Bezug nehmend auf Fig. 4 eine praktische Realisierung der elektronischen Schalteranordnung 300 gemäß dem zweiten Ausführungsbeispiel der vorliegenden Erfindung detailliert dargestellt.

Bei der in Fig. 4 dargestellten elektronischen Schalteranordnung 300 wird der in Fig. 2 dargestellte n-Typ-MOSFET 102 gemäß dem ersten Ausführungsbeispiel der vorliegenden Erfindung durch eine Kaskodenschaltung 302 mehrerer Niedervolt-n-Typ-MOSFETs 304, 306, 308 ersetzt.

Um diese n-Typ-MOSFETs 304, 306, 308 geeignet anzusteuern, werden die Potentiale an dem äußeren Anodenanschluss 106a und dem äußeren Kathodenanschluss 106b der bipolaren Ladungspumpe 106 mit einem ersten und zweiten Spannungsteiler Z0-Z4 und Z5-Z9 geeignet unterteilt und mit isolierten Hochvolt-p-Typ-MOSFETs 402, 404, 406, 408 bzw. Niedervolt-n-Typ-MOSFET-Kaskoden 410, 412, 414 an die Gate-Anschlüsse der n-Typ-MOSFETs 304, 306, 308 durchgeschaltet.

Die Niedervolt-n-Typ-MOSFETs 304, 306, 308 sind dabei in Triple-Well-Technologie (vgl. Fig. 6a) ausgeführt und liegen in einer gemeinsamen äußeren n-Typ-Wanne 416, deren Potential an den äußeren Kathodenanschluss 106b der bipolaren Ladungspumpe 106 geschaltet ist.

Bei der in Fig. 4 dargestellten elektronischen Schalteranordnung ist es nun vorteilhaft, dass es bei den dort verwendeten n-Typ-MOSFETs 304, 306, 308 nicht mehr erforderlich ist, einerseits eine hohe Durchbruchspannung an dem Drain-Bereich vorzusehen und gleichzeitig einen isolierten p-Bulk-Bereich zur Verfügung zu stellen.

Im folgenden wird nun auf den ersten Betriebszustand der bipolare Ladungspumpe 106 eingegangen, wobei das Betriebszustandssignal S_{BZ} an dem Signaleingang 304 in dem ersten Betriebszustand vorzugsweise einen Spannungspegel aufweist, der der Betriebsspannung V_{DD} entspricht.

Liegt also an dem Signaleingang 204 das Betriebszustandssignal S_{BZ} mit einem Potential von V_{DD} an, sperrt der p-Typ-MOSFET 302 und der n-Typ-MOSFET 308 leitet ein Potential von 0 V an den äußeren Kathodenanschluss 106b der bipolaren Ladungspumpe 106. An dem äußeren Anodenanschluss 106a der bipolaren Ladungspumpe 106 entsteht also die hohe negative Ausgangsspannung V_{neg}. Die p-Typ-MOSFETs 402 und 404 sperren, da sie von dem zweiten Spannungsteiler Z5-Z9 jeweils mit einem Gate-Source-Potential von 0 V angesteuert werden.

Da es sich bei den p-Typ-MOSFET 402, 404 um Hochvolttransistoren handelt, deren Drain-Anschluss jeweils an dem Gate-Anschluss der n-Typ-MOSFETs 306 und 308 anliegt, macht diesen Feldeffekttransistoren die in der Folge dort anliegende hohe negative Ausgangsspannung V_{neg} der bipolaren Ladungspumpe 106 nichts aus. Der n-Bulk-Bereich dieser FETs 402, 404 liegt an einem Potential von 0 V, also an dem höheren der beiden Potentiale zwischen dem Drain- und dem Source-Anschluss, so dass beide p-Typ-MOSFETs 402, 404 tatsächlich sperren.

Der erste Spannungsteiler Z0-Z4 ist nun so dimensioniert, dass an dem Knoten p2a etwa ein Potential von (V_{neg} + V_{DD}) entsteht, so dass der p-Typ-MOSFET 406 mit der maximal erlaubten Gate-Source-Spannung von (V_{gs} = V_{DD}) angesteuert wird, wobei in der Folge auch der NV-n-Typ-MOSFET 304 mit der maximalen Gate-Source-Spannung von V_{DD} eingeschaltet wird, d. h. sein Gate-Anschluss liegt also an einem Potential von (V_{neg} + V_{DD}).

Der Bulk-Anschluß des p-Typ-MOSFET 406 in Fig. 4 ist mit der positiven Versorgungsspannung 206 (V_{DD}) verbunden, da der Bulk-Bereich eines Feldeffekttransistors i. a. immer an dem höheren Potential, das an dem Drain- oder dem Source-Anschluss des Feldeffekttransistors zu erwarten ist, anliegen sollte.

Der NV-n-Typ-MOSFET 304 ist somit also leitend, so dass an dem Source-Anschluss des NV-n-Typ-MOSFET 306 die hohe negative Ausgangsspannung V_{neg} anliegt. Außerdem ist der erste Spannungsteiler Z0-Z4 so dimensioniert, dass der Knoten p0 auf einem Potential von etwa (V_{neg} + 2 * V_{DD}) liegt, und somit der NV-n-Typ-MOSFET 414 mit der maximal erlaubten Gate-Steuerspannung leitend wird, so dass auch der Gate-Anschluss des NV-n-Typ-MOSFET 306 auf einem Potential von (V_{neg} + V_{DD}) liegt und somit dieser MOSFET 306 gut leitend ist.

Um nun auch den NV-n-Typ-MOSFET 308 leitend zu schalten, müssen die beiden NV-n-Typ-MOSFETs 412, 410 ein Potential, das zwischen der hohen negativen Ausgangsspannung V_{neg} und dem Potential (V_{neg} + V_{DD}) liegt, an dessen Gate-Anschluss durchschalten. Andererseits muss auch der NV-n-Typ-MOSFET 410 leitend sein, indem dessen Gate-Anschluss das gleiche Potential hat, wie der NV-n-Typ-MOSFET 306, d. h. ein Potential von (V_{neg} + V_{DD}). Mit diesem Gate-Potential kann der NV-n-Typ-MOSFET 410 nur dann leitend werden, wenn sein Kanalbereich ein negativeres Potential als das Potential (V_{neg} + V_{DD} - Vₜₙ) aufweist, wobei Vₜₙ die Schwellenspannung eines NV-n-Typ-MOSFETs ist. Andererseits muss der Gate-Anschluss des NV-n-Typ-MOSFET 308 auf einem höheren Potential liegen als das Potential (V_{neg} + Vₜₙ), denn nur dann ist der NV-n-Typ-MOSFET 308 leitend. Daher muss das Potential an dem Knoten p3a zwischen einem Potential von (V_{neg} + Vₜₙ) und einem Potential von (V_{neg} + V_{DD} - Vₜₙ) liegen. Aus diesem Grund wird das Potential an dem Knoten p3a auf einen Wert von etwa (V_{neg} + V_{DD}/2) eingestellt. Das Potential an dem Knoten p1 des ersten Spannungsteilers stellt man dementsprechend auf einen Wert von (V_{neg} + 3 * V_{DD}/2) ein. Somit leitet der NV-n-Typ-MOSFET 412 sehr gut, der NV-n-Typ-MOSFET 410 immer noch hinreichend, und der NV-n-Typ-MOSFET 308 ebenfalls hinreichend.

Die beiden letztgenannten MOSFETs 410, 308 weisen jeweils eine Gate-Source-Spannung von (V_{DD}/2) auf. Solange sichergestellt ist, dass die Betriebsspannung V_{DD} größer als die doppelte. n-Typ-MOSFET-Schwellenspannung Vₜₙ ist, ist dieses Verfahren wirksam.

Im folgenden wird nun bezüglich der in Fig. 4 dargestellten elektronischen Schalteranordnung 300 auf den zweiten Betriebszustand der elektronischen Schaltung 106, d. h. der bipolaren Ladungspumpe, eingegangen.

Bei dem zweiten Betriebszustand ist das Betriebszustandssignal S_{BZ} an dem Signaleingang 204 der Schalteranordnung 300 vorzugsweise auf einem Potential von 0 V. Daher leitet der p-Typ-MOSFET 302 das Potential V_{DD} , d. h. die Betriebsspannung 306, an den äußeren Anodenanschluss 106a der bipolaren Ladungspumpe 106. Ferner sperrt der n-Typ-MOSFET 308, so dass sich an dem äußeren Kathodenanschluss 106b der bipolaren Ladungspumpe 106 die hohe positive Ausgangsspannung Vₚₒₛ der bipolaren Ladungspumpe 106 bildet.

Die NV-n-Typ-MOSFETs 304, 306, 308 bilden nun eine Kaskodenschaltung, die sperrt. Dazu wird der zweite Spannungsteiler Z5-Z9 so dimensioniert, dass an dem Knoten p6 des zweiten Spannungsteilers das Potential (Vₚₒₛ - V_{DD}), und an dem Knoten p7 des zweiten Spannungsteilers das Potential (Vₚₒₛ - 2 * V_{DD}) anliegt.

Der p-Typ-MOSFET 402 ist somit leitend und legt an den Gate-Anschluss des n-Typ-MOSFET 308 ein Potential von (Vₚₒₛ - V_{DD}). Es ist zu beachten, dass dieses Potential nicht niedriger liegen darf, denn die maximale Gate-Drain-Spannung eines NVn-Typ-MOSFET ist mit einem Potential, das etwa der Betriebsspannung V_{DD} entspricht, begrenzt. Der n-Typ-MOSFET 308 sperrt, wobei sich an seinem Source-Anschluss ebenfalls das Potential (Vₚₒₛ - V_{DD}) einstellt.

Ferner wird die Impedanz Z7 des zweiten Spannungsteilers sehr niedrig gewählt (ungefähr 0Ω) und die weiteren Impedanzen Z5-Z9 des zweiten Spannungsteilers so dimensioniert, dass an dem Knoten p9 des zweiten Spannungsteilers das Potential (Vₚₒₛ - 3 * V_{DD}) anliegt. Damit leitet auch der p-Typ-MOSFET 404, so dass der Gate-Anschluss des n-Typ-MOSFET 306 an einem Potential von (Vₚₒₛ - 2 * V_{DD}) anliegt. Der NV-n-Typ-MOSFET 306 sperrt ebenfalls, wobei sich an seinem Source-Anschluss das Potential (Vₚₒₛ - 2 * V_{DD}) einstellt. Der Gate-Anschluss des NV-n-Typ-MOSFET 304 wird über den p-Typ-MOSFET 408 an die Betriebsspannung V_{DD} gelegt, so dass der NV-n-Typ-MOSFET 304 ebenfalls sperrt.

Um die n-Typ-MOSFETs 304, 306, 308 nicht mit einer unzulässig hohen Gate-Drain-Spannung zu belasten, muss die hohe positive Ausgangsspannung (Vₚₒₛ < 4 * V_{DD}) sein. Gleichzeitig werden auch diejenigen Niedervolt-n-Typ-MOSFETs 410, 414, die die Gate-Anschlüsse der n-Typ-MOSFETs 306, 308 im Falle negativer Pumpspannung mit den Spannungsabgriffen des ersten Spannungsteilers Z0-Z4 verbinden, nur mit zulässigen Sperrspannungen (V_{Gate-Drain} < V_{DD}) belastet, denn der Knoten p3c liegt auf einem Potential von (Vₚₒₛ - V_{DD}), und der Knoten p2b liegt auf einem Potential von (Vₚₒₛ - 2 * V_{DD}). Somit sperrt der n-Typ-Transistor 410, und der Knoten p3b liegt auf einem Potential von (Vₚₒₛ - 2 * V_{DD}). Gleichzeitig liegen aber alle Teile des ersten Spannungsteilers Z0-Z4 an dem Potential V_{DD}, weil die beiden Enden des ersten Spannungsteilers an dem Potential V_{DD} liegen.

Dadurch werden auch die n-Typ-MOSFETs 412 und 414 nur mit maximal einem Potential von V_{DD} zwischen dem Gate- und dem Drain-Bereich, sowie zwischen dem Source- und dem Drain-Bereich belastet, da gilt (Vₚₒₛ < 4 * V_{DD}). Außerdem befindet sich der p-Bulk-Bereich der n-Typ-MOSFETs 412 und 414 am jeweils niedrigeren Potential zwischen dem Drain- und dem Source-Anschluss.

Bei der anhand von Fig. 4 beschriebenen elektronischen Schalteranordnung 300 wird das erste Bezugspotential U_{bez1} an dem ersten Spannungsteiler Z0-Z4 und das zweite Bezugspotential U_{bez2} an dem zweiten Spannungsteiler Z5-Z9 mit einem Invertierer 418 durch Invertieren des Betriebszustandssignal S_{BZ} an dem Signaleingang 204 erhalten.

Das im vorhergehenden geschilderte Prinzip zum Aufbau einer elektronischen Schalteranordnung kann auch noch auf höhere Spannungen Vₚₒₛ erweitert werden, in dem weitere NV-n-Typ-MOSFET in Serie zu den NV-n-Typ-MOSFETs 304, 306, 308 und 412, 410, 414 geschaltet werden und nach dem oben erörterten Prinzip angesteuert werden.

Falls beispielsweise die hohe positive Ausgangsspannung Vₚₒₛ dem fünffachen Wert der Betriebsspannung V_{DD} entspricht, d. h. (Vₚₒₛ = 5 * V_{DD}), ist es beispielsweise notwendig, zu den drei NV-n-Typ-MOSFETs 304, 306, 308 noch einen weiteren NV-n-Typ-MOSFET in Serie zu schalten, d. h. die Kaskodenschaltung auf vier MOSFETs zu erweitern. Falls die bipolare Ladungspumpe 106 dann bei dem zweiten Betriebszustand eine hohe negative Spannung erzeugt, wird an dem Gate-Anschluss des NV-n-Typ-MOSFET, der hinzugefügt wurde, ein Potential von (V_{neg} + V_{DD}/3), an den Gate-Anschluss des NV-n-Typ-MOSFET 308 ein Potential von (V_{neg} + 2 * V_{DD}/3) und an den Gate-Anschluss des NV-n-Typ-MOSFETs 306 und 304 ein Potential von (V_{neg} + V_{DD}) angelegt.

Im folgenden wird zur Verdeutlichung des erfindungsgemäßen Konzepts bezugnehmend auf Fig. 4 die praktische Realisierung der elektronischen Schalteranordnung gemäß dem zweiten Ausführungsbeispiel der vorliegenden Erfindung nochmals zusammengefasst erläutert.

Bei dem in Fig. 4 dargestellten zweiten Ausführungsbeispiel der erfindungsgemäßen elektronischen Schalteranordnung 300 wird der als elektronischer Schalter wirksame n-Typ-Feldeffekttransistor 102 (des ersten Ausführungsbeispiels) durch mehrere (z. B. drei) in Serie geschaltete Standard-Niedervolt-n-Typ-MOSFETs 304, 306, 308 ersetzt, von denen jeder..e.inzelne einen isolierten Bulk-Bereich besitzt. Außerdem sind die Durchbruchspannungen am Drain/Source- zu Bulk-Bereich sowie an dem Bulk-Bereich zu dem Substrat generell bei üblicher Technologie auf die maximale Ausgangsspannung der elektronischen Schaltung, d. h. beispielsweise auf die hohe negative Ausgangsspannung V_{neg} und die hohe positive Ausgangsspannung Vₚₒₛ einer bipolaren Ladungspumpe, erhöht. Die Anforderungen an die Gate-Kanal-Durchbruchsicherheit sowie an die Drain-Source-Durchbruchsicherheit entsprechen jedoch jenen von Standard-NV-n-Typ-MOSFETs (NV = Niedervolt), wobei die Durchbruchspannungen üblicherweise in der Größenordnung der Betriebsspannung V_{DD} der elektronischen Schaltung liegen.

Bei dieser elektronischen Schalteranordnung 300 gemäß dem zweiten Ausführungsbeispiel der vorliegenden Erfindung werden die Steuereingänge, d. h. die Gate-Anschlüsse von beispielsweise drei NV-n-Typ-MOSFETs 304, 306, 308 so angesteuert, dass diese MOSFETs die hohe negative Spannung V_{neg} an dem ersten Ausgang der elektronischen Schaltung durchlassen, da (im Fall einer Kaskode aus drei FETs) ihre Gate-Anschlüsse dann alle auf einem Potential von (V_{neg} + V_{GS-max}/2) oder (V_{neg} + V_{GS}-ₘₐₓ) liegen, und andererseits die an dem zweiten Schalteranschluss anliegende hohe positive Spannung Vₚₒₛ bei dem zweiten Betriebszustand der elektronischen Schaltung sicher sperren. In dem letzteren Fall erhalten die Gate-Anschlüsse, d. h. die Steuereingänge, der drei NV-n-Typ-MOSFETs 304, 306, 308 ein unterschiedlich abgestuftes Potential. Damit kann diese beispielsweise drei-stufige NV-n-Typ-MOSFET-Kaskode eine maximale positive Ausgangsspannung Vₚₒₛ von etwa (Vₚₒₛ = V_{DD} + 3 * V_{GS-max} ≈ 4 * V_{DD}) sicher sperren.

Will man noch größere Spannungen sperren, so kann die Kaskode nach dem gleichen Schema erweitert werden. Besteht also die NV-n-Typ-MOSFET-Kaskode aus k Transistoren, so wird der Gate-Anschluss des m-ten Transistors im Falle einer hohen positiven Ausgangsspannung an dem zweiten Ausgang der elektronischen Schaltung mit einer Spannung (V_{DD} + (m-1) * V_{GS-max}) angesteuert, so dass Spannungen von bis zu dem (k+1)-fachen Wert der maximalen Gate-Source-Spannung V_{GS-max} durch die Kaskodenschaltung von dem ersten Anschluss der elektronischen Schaltung, d. h. beispielsweise von dem äußeren Anodenanschluss einer bipolaren Ladungspumpe, isoliert werden können.

Die abgestuften Steuerspannungen für die Steuereingänge, d. h. Gate-Anschlüsse der NV-n-Typ-MOSFET der Kaskodenschaltung, werden nun an einem modifizierten Spannungsteiler gewonnen, der eine entsprechend erhöhte Anzahl von Impedanzelementen aufweist, wobei die Anzahl der nun vorhandenen Spannungsteilerabgriffe beispielsweise der Anzahl der Steuereingänge des elektronischen Schalters, d. h. der Anzahl der Gate-Anschlüsse der MOSFETs, entspricht. Dazu wird der modifizierte Spannungsteiler analog zu den bereits ausführlich erläuterten Dimensionierungsregeln aufgebaut.

Der erste Spannungsteiler ist also derart dimensioniert, dass an die Kaskode aus NV-n-Typ-MOSFETs bei dem ersten Betriebszustand geeignete Steuersignale an deren Steuereingängen, d. h. an den jeweiligen Gate-Anschlüssen der NV-n-Typ-MOSFETs, angelegt sind. Bei dem ersten Betriebszustand lässt die Kaskodenschaltung das Ausgangssignal der elektronischen Schaltung durch, das einen hohen negativen Spannungspegel aufweist. Die entsprechenden Steuerspannungen, d. h. Spannungen an den entsprechenden Gate-Anschlüssen der NV-n-Typ-MOSFET der Kaskodenschaltung, werden bei dem zweiten Betriebszustand durch eine geeignete Dimensionierung eines zweiten Spannungsteilers wieder mit einer Mehrzahl von Impedanzelementen eingestellt. Die an dem ersten und zweiten Spannungsteiler eingestellten Gate-Spannungen für die NV-n-Typ-MOSFETs der Kaskode werden im Falle einer hohen negativen Ausgangsspannung an dem ersten Ausgang der Schaltungseinrichtung, d. h. bei dem ersten Betriebszustand durch eine Umschalteinrichtung an die entsprechenden Gate-Anschlüsse geschaltet, wobei im Falle einer hohen positiven Ausgangsspannung an dem zweiten Ausgang der elektronischen Schaltungseinrichtung die an dem zweiten Spannungsteiler eingestellten Gate-Spannungen an die entsprechenden Gate-Anschlüsse der n-Typ-MOSFETs der Kaskode geschaltet werden.

Es ist zu beachten, dass durch den ersten und zweiten Spannungsteiler in beiden Betriebszuständen der elektronischen Schaltung die maximale Gate-Source-Durchbruchspannung an den einzelnen n-Typ-MOSFETs der Kaskodenschaltung durch die geeignete Dimensionierung der einzelnen Impedanzelemente des ersten und zweiten Spannungsteilers nicht überschritten wird. Dadurch ergibt sich eine starke Vereinfachung bei der prozesstechnischen Herstellung eines integrierten Schaltkreises (IC) unter Verwendung der erfindungsgemäßen elektronischen Schalteranordnung.

Um die NV-n-Typ-MOSFETs der Kaskodenschaltung sowohl bei einer hohen positiven als auch bei einer hohen negativen Ausgangsspannung der elektronischen Schaltung, d. h. sowohl bei dem ersten als auch zweiten Betriebszustand der elektronischen Schaltung, vom Substrat zu isolieren, sind diese Transistoren in einer sogenannten Triple-Well-Technologie aufgebaut. Alle NV-n-Typ-MOSFETs der Kaskodenschaltung können dabei in einer gemeinsamen äußeren n-Wanne liegen. Bei hohen negativen Spannungen der elektronischen Schaltung an deren ersten Ausgang im ersten Betriebszustand wird die n-Typ-Wanne auf ein Potential von 0 V oder auf ein positives Potential gelegt. Bei hohen positiven Ausgangsspannungen der elektronischen Schaltung, d. h. bei dem zweiten Betriebszustand der bipolaren Ladungspumpe, wird diese n-Typ-Wanne mit der hohen positiven Ausgangsspannung Vₚₒₛ der elektronischen Schaltung verbunden.

Aus der obigen Beschreibung wird ferner deutlich, dass die Anforderungen an die Gate-Kanal-Durchbruchsicherheit sowie an die Drain-Source-Durchbruchsicherheit der NV-n-Typ-MOSFETs der Kaskodenschaltung, wie sie bei der vorliegenden Erfindung verwendet werden, lediglich jenen Anforderungen von Standard-NV-n-Typ-MOSFETs (NV = Niedervolt) entsprechen brauchen, wobei die Durchbruchspannungen üblicherweise in der Größenordnung der Betriebsspannung V_{DD} der elektronischen Schaltung liegen.

### Bezugszeichenliste

- 100: Elektronische Schalteranordnung
- 102: Elektronischer Schalter
- 102a: Erster Schalteranschluss
- 102b: Zweiter Schalteranschluss
- 102c: Steuereingang
- 104: Spannungsteileranordnung
- 104a: Erster Spannungsteileranschluss
- 104b: Zweiter Spannungsteileranschluss
- 104c: Spannungsteilerabgriff
- 106: Elektronische Schaltung
- 106a: Erster Ausgang
- 106b: Zweiter Ausgang
- 106c: Signaleingang
- 108: Ausgangsport
- 200: Elektronischer Schalter
- 202: FET-Schalter
- 202a: Erster Anschluss
- 202b: Zweiter Anschluss
- 202c: Steuereingang
- 204: Signaleingang
- 206: Versorgungsspannung
- 208: Elektronischer FET-Schalter
- 208a: Erster Anschluss
- 208b: Zweiter Anschluss
- 208c: Steueranschluss
- 210: Elektronischer FET-Schalter
- 210a: Erster Anschluss
- 210b: Zweiter Anschluss
- 210c: Steuereingang
- 212: Zweiter Spannungsteiler
- 212a: Erster Spannungsteileranschluss
- 212b: Zweiter Spannungsteileranschluss
- 212c: Spannungsteilerabgriff
- 300: Elektronische Schaltanordnung
- 302: Elektronischer FET-Schalter
- 302a: Erster Anschluss
- 302b: Zweiter Anschluss
- 302c-e: Steuereingänge
- 304: n-Typ-Feldeffekttransistor
- 306: n-Typ-Feldeffekttransistor
- 308: n-Typ-Feldeffekttransistor
- 310: Erste Spannungsteileranordnung
- 312: Erster Spannungsteileranschluss
- 314: Zweiter Spannungsteileranschluss
- 316-320: Spannungsteilerabgriffe
- 322: Zweite Spannungsteileranordnung
- 324: Erster Spannungsteileranschluss
- 326: Zweiter Spannungsteileranschluss
- 328-332: Spannungsteilerabgriffe
- 338: Umschalteinrichtung
- 402-408: p-Typ-MOSFET
- 410-414: n-Typ-MOSFET

## Patentansprüche

1. Elektronische Schalteranordnung (100) zum Durchschalten eines Signals (U1) an einem ersten Ausgang (106a) einer elektronischen Schaltung (106) an einen Gesamtausgang (108), mit folgenden Merkmalen:
einer Spannungsteileranordnung (104) aus zumindest zwei Impedanzelementen (Z1, Z2), wobei die Spannungsteileranordnung (104) einen ersten Spannungsteileranschluss (104a), einen zweiten Spannungsteileranschluss (104b) und einen Spannungsteilerabgriff (104c) aufweist, wobei der erste Spannungsteileranschluss (104a) mit dem ersten Ausgang (106a) der elektronischen Schaltung (106) verbunden ist, und der zweite Spannungsteileranschluss (106b) mit einem Bezugspotential (U_{bez}) verbunden ist,
einem elektronischen Schalter (102) mit einem ersten Schalteranschluss (102a), einem zweiten Schalteranschluss (102b) und einem Steuereingang (102c), wobei der erste Schalteranschluss (102a) mit dem ersten Ausgang (106a) der elektronischen Schaltung (106) und dem ersten Spannungsteileranschluss verbunden (104a) ist, und der zweite Schalteranschluss (102b) mit einem zweiten Ausgang (106b) der elektronischen Schaltung (106) verbunden ist, und der Steuereingang (102c) mit dem Spannungsteilerabgriff (104c) verbunden ist,
wobei bei einem ersten Betriebszustand der elektronischen Schaltung (106) das Signal (U₁) an dem ersten Ausgang (106a) derselben einen ersten Spannungspegel (U₁₋₁) aufweist, der betragsmäßig größer als eine Referenzspannung (Vₚₚ) der elektronischen Schaltung (106) ist, und bei einem zweiten Betriebszustand der elektronischen Schaltung (106) das Signal (U₁) an dem ersten Ausgang (106a) einen zweiten Spannungspegel (U₁₋₂) aufweist, der betragsmäßig kleiner oder gleich der Referenzspannung (Vₚₚ) ist, und
wobei die Impedanzelemente (Z1, Z2) der Spannungsteileranordnung so dimensioniert sind, dass an dem Spannungsteilerabgriff (104c) eine Steuerspannung (Vₛₜₑᵤₑᵣ) bereitgestellt wird, die so beschaffen ist, dass der elektronische Schalter (102) bei dem ersten Betriebszustand das Signal (U₁) von dem ersten Schalteranschluss (102a) an den Gesamtausgang (108) durchschaltet, und der elektronische Schalter (102) bei dem zweiten Betriebszustand den ersten Ausgang (106a) von dem Gesamtausgang (108) trennt.

2. Schalteranordnung nach Anspruch 1, bei der der elektronische Schalter (102) ein Feldeffekttransistor eines ersten Leitfähigkeitstyps mit einem Drain-Anschluss, einem Source-Anschluss, einem Gate-Anschluss und einem Bulk-Bereich ist, wobei der Source-Anschluss dem ersten Schalteranschluss (102a), der Drain-Anschluss dem zweiten Schalteranschluss (102b) und der Gate-Anschluss dem Steuereingang (102c) des elektronischen Schalters (102) zugeordnet ist.

3. Schalteranordnung nach Anspruch 2, bei der der Feldeffekttransistor einen isolierten Bulk-Bereich aufweist.

4. Schalteranordnung nach Anspruch 2 oder 3, bei der der Feldeffekttransistor zwischen seinem Gate- und Source-Anschluss eine Gate/Source-Durchbruchspannung aufweist, wobei sowohl bei dem ersten als auch bei dem zweiten Betriebszustand die Spannungsdifferenz zwischen dem Steuereingang (102c) und dem ersten Schalteranschluss (102a) des elektronischen Schalters(102) kleiner oder gleich der Gate/Source-Durchbruchspannung ist.

5. Schalteranordnung nach Anspruch 4, bei der die Gate/Source-Durchbruchspannung des Feldeffekttransistors der Referenzspannung (V_{DD}) entspricht.

6. Schalteranordnung nach Anspruch 4 oder 5, bei der die Impedanzelemente (Z1, Z2) der Spannungsteileranordnung (104) so dimensioniert sind, dass an dem Spannungsteilerabgriff (104c) ein Spannungspegel (Vₛₜₑᵤₑᵣ₁) anliegt, der kleiner oder gleich der Gate/Source-Durchbruchspannung des Feldeffekttransistors ist.

7. Schalteranordnung nach einem der Ansprüche 2 bis 6, bei der der Feldeffekttransistor an seinem Drain-Anschluss eine Drain-Durchbruchspannung aufweist, die zumindest dem ersten Spannungspegel (U₁₋₁) entspricht.

8. Schalteranordnung nach einem der Ansprüche 1 bis 7, bei der das Bezugspotential (U_{bez}), das an dem zweiten Spannungsteileranschluss (104b) anliegt, Massepotential ist, und
bei der die Referenzspannung (V_{DD}) die Betriebsspannung der elektronischen Schaltung (106) ist.

9. Schalteranordnung nach einem der Ansprüche 1 bis 8, bei der die Impedanzelemente (Z1, Z2) der Spannungsteileranordnung (104) resistive und/oder kapazitive Schaltungslemente sind.

10. Schalteranordnung nach einem der Ansprüche 1 bis 9, die ferner folgende Merkmale aufweist:
eine weitere Spannungsteileranordnung (212) aus zumindest zwei Impedanzelementen (Z3, Z4), wobei die weitere Spannungsteileranordnung (212) einen dritten Spannungsteileranschluss (212a), einen vierten Spannungsteileranschluss (212b) und einen zweiten Spannungsteilerabgriff (212c) aufweist, wobei der dritte Spannungsteileranschluss (212a) mit dem zweiten Ausgang (106b) der elektronischen Schaltung (106) verbunden ist, und der vierte Spannungsteileranschluss (212b) mit einem Bezugspotential verbunden ist, und
einen weiteren elektronischen Schalter (210) mit einem dritten Schalteranschluss (210a), einem vierten Schalteranschluss (210b) und einem zweiten Steuereingang (210c), wobei der dritte Schalteranschluss (210a) mit dem zweiten Ausgang (106b) der elektronischen Schaltung (106) und dem dritten Spannungsteileranschluss (212a) der weiteren Spannungsteileranordnung (212) verbunden ist, und der vierte Schalteranschluss (210b) mit dem ersten Ausgang (106a) der elektronischen Schaltung (106) verbunden ist, und der zweite Steuereingang (210c) mit dem zweiten Spannungsteilerabgriff (212c) der weiteren Spannungsteileranordnung (212) verbunden ist,
wobei bei dem ersten Betriebszustand ein zweites Signal (U₂) an dem zweiten Ausgang (106b) der elektronischen Schaltung (106) einen dritten Spannungspegel (U₂₋₁) aufweist, der betragsmäßig kleiner oder gleich der Referenzspannung (V_{DD}) ist, und bei dem zweiten Betriebszustand das zweite Signal (U₂) an dem zweiten Ausgang (106b) einen vierten Spannungspegel (U₂₋₂) hat, der betragsmäßig größer als die Referenzspannung (V_{DD}) ist, und
wobei die Impedanzelemente (Z3, Z4) der weiteren Spannungsteileranordnung (212) so dimensioniert sind, dass an dem zweiten Spannungsteilerabgriff (212c) der weiteren Spannungsteileranordnung (212) eine zweite Steuerspannung (Vₛₜₑᵤₑᵣ₂) bereitgestellt wird, so dass der weitere elektronische Schalter (210) bei dem ersten Betriebszustand den zweiten Ausgang (106b) der elektronischen Schaltung (106) von dem Gesamtausgang (108) der elektronischen Schalteranordnung (100) trennt, und der weitere elektronische Schalter (210) bei dem zweiten Betriebszustand das zweite Signal (U₂) an dem zweiten Ausgang (106b) von dem dritten Schalteranschluss (210a) des weiteren elektronischen Schalters (210) an den Gesamtausgang (108) der elektronischen Schalteranordnung (100) durchschaltet.

11. Schalteranordnung nach Anspruch 10, bei der der weitere elektronische Schalter (210) einen weiteren Feldeffekttransistor mit einem Drain-Anschluss, einem Source-Anschluss, einem Gate-Anschluss und einem Bulk-Bereich ist, wobei der Source-Anschluss dem dritten Schalteranschluss (310a), der Drain-Anschluss dem vierten Schalteranschluss (310b) und der Gate-Anschluss dem zweiten Steuereingang (310c) des weiteren elektronischen Schalters (210) zugeordnet ist.

12. Schalteranordnung nach Anspruch 11, bei der der weitere Feldeffekttransistor (210) einen isolierten Bulk-Bereich aufweist.

13. Schalteranordnung nach einem der Ansprüche 10 bis 12, bei der der weitere Feldeffekttransistor (210) zwischen seinem Gate- und Source-Anschluss eine Gate/Source-Durchbruchspannung aufweist, wobei sowohl bei dem ersten als auch dem zweiten Betriebszustand die Spannungsdifferenz zwischen dem Steuereingang (210c) und dem ersten Schalteranschluss (210a) des weiteren elektronischen Schalters (210) kleiner oder gleich der Gate/Source-Durchbruchspannung ist.

14. Schalteranordnung nach Anspruch 13, bei der die Gate/Source-Durchbruchspannung des weiteren Feldeffekttransistors der Referenzspannung (V_{DD}) entspricht.

15. Schalteranordnung nach Anspruch 13 oder 14, bei der die Impedanzelemente (Z3, Z4) der weiteren Spannungsteileranordnung (212) so dimensioniert sind, dass an den zweiten Spannungsteilerabgriff (212c) ein Spannungspegel (Vₛₜₑᵤₑᵣ₂) anliegt, der kleiner oder gleich der Gate/Source-Durchbruchspannung des weiteren Feldeffekttransistors (210) ist.

16. Schalteranordnung nach einem der Ansprüche 11 bis 15, bei der der weitere Feldeffekttransistor (210) an seinem Drain-Anschluss (210b) eine Drain-Durchbruchspannung aufweist, die zumindest dem ersten Spannungspegel (U₁₋₁) entspricht.

17. Schalteranordnung nach einem der Ansprüche 10 bis 16, bei der das Bezugspotential (U_{bez}), das an dem zweiten Spannungsteileranschluss (212b) der weiteren Spannungsteileranordnung (212) anliegt, Massepotential ist, und
bei der die Referenzspannung (V_{DD}) die Betriebsspannung der elektronischen Schaltung (106) ist.

18. Schalteranordnung nach einem der Ansprüche 10 bis 17, bei der die Impedanzelemente (z3, Z4) der weiteren Spannungsteileranordnung resistive und/oder kapazitive Schaltungselemente sind.

19. Schalteranordnung nach einem der Ansprüche 1 bis 18, bei der die elektronische Schaltung (106) eine bipolare Ladungspumpe ist.

20. Schalteranordnung nach Anspruch 19, bei der bei dem ersten Betriebszustand der erste Spannungspegel (U₁₋₁) an dem ersten Ausgang (106a) der bipolaren Ladungspumpe eine hohe negative Spannung (Vₚₒₛ) ist, und der dritte Spannungspegel (U₂₋₁) an dem zweiten Ausgang (106b) zwischen Massepotential und der Referenzspannung (V_{DD}) liegt, und wobei bei dem zweiten Betriebszustand der zweite Spannungspegel (U₁₋₁) an dem ersten Ausgang (106a) zwischen Massepotential und der Referenzspannung (V_{DD}) liegt, und ein vierter Spannungspegel (U₂₋₂) an dem zweiten Ausgang (106b) eine hohe positive Spannung (Vₚₒₛ) ist.

21. Schalteranordnung nach Anspruch 20, bei dem der Feldeffekttransistor 102 des elektronischen Schalters 100 ein n-Typ-MOSFET und der weitere Feldeffekttransistor 210 des weiteren elektronischen Schalters 200 ein p-Typ-MOSFET ist.

22. Schalteranordnung nach einem der Ansprüche 1 bis 21, wobei der elektronische Schalter (302) eine Mehrzahl von n n-Typ-Feldeffekttransistoren (304, 306, 308) aufweist, wobei n die Anzahl der Feldeffekttransistoren ist, wobei die n n-Typ-Feldeffekttransistoren (304, 306, 308) eine Kaskodenschaltung bilden, wobei der Source-Anschluss des ersten n-Typ-Feldeffekttransistors dem ersten Schalteranschluss zugeordnet ist, und der Drain-Anschluss des n-ten n-Typ-Feldeffekttransistors dem zweiten Schalteranschluss zugeordnet ist, und wobei jeder n-Typ-Feldeffekttransistor einen Gate-Anschluss aufweist, und jedem Gate-Anschluss ein Steuereingang des elektronischen Schalters zugeordnet ist,
wobei jeder Steuereingang des elektronischen Schalters (302) mit einer Steuerspannung angesteuert wird, wobei die Steuerspannung zwischen der Mehrzahl von n n-Typ-Feldeffektransistoren (304, 306, 308) so abgestuft ist, dass die Kaskodenschaltung aus der Mehrzahl von Feldeffekttransistoren während des ersten Betriebszustands leitet, und dass die Kaskodenschaltung in dem zweiten Betriebszustand sperrt, und dass die Gate/Source-Spannung zwischen dem Gate- und Source-Anschluß jedes Feldeffekttransistors der Kaskode und die Drain/Source-Spannung zwischen dem Drain- und Source-Anschluß jedes Feldeffekttransistors der Kaskode und die Gate/Kanal-Spannung zwischen dem Gate-Anschluß und dem Kanalbereich jedes Feldeffekttransistors der Kaskode kleiner oder gleich der Referenzspannung ist.

23. Schalteranordnung nach Anspruch 22, wobei die Spannungsteileranordnung eine Mehrzahl von n+1 Impedanzelementen (Z0-Z4) und n Spannungsteilerabgriffe aufweist, und ferner die weitere Spannungsteileranordnung eine Mehrzahl von n+1 Impedanzelementen (Z5-Z9) und n Spannungsteilerabgriffe aufweist, wobei der erste Ausgang der elektronischen Schaltung mit dem ersten Spannungsteileranschluss der Spannungsteileranordnung verbunden ist, und bei dem ersten Betriebszustand ein erstes Bezugspotential U_{bez} mit dem zweiten Spannungsteileranschluss verbunden ist, wobei die Mehrzahl von n Spannungsteilerabgriffen der Spannungsteileranordnung mit den jeweiligen Steuereingängen des elektronischen Schalters (302) verbunden sind,
wobei der zweite Ausgang der elektronischen Schaltung (106) mit dem ersten Spannungsteileranschluss der weiteren Spannungsteileranordnung verbunden ist, und bei dem zweiten Betriebszustand eine zweite Bezugsspannung (U_{bez2}) mit dem zweiten Spannungsteileranschluss der weiteren Spannungsteileranordnung verbunden ist, wobei die Mehrzahl von n Spannungsteilerabgriffen der weiteren Spannungsteileranordnung mit den jeweiligen Steuereingängen des elektronischen Schalters (302) verbunden sind.
wobei die Impedanzelemente (Z0-Z4) der Spannungsteileranordnung und die Impedanzelemente (Z5-Z9) der weiteen Spannungsteileranordnung so dimensioniert sind, dass in dem ersten und dem zweiten Betriebszustand an den Mittelabgriffen der Spannungsteileranordnung und der weiteren Spannungsteileranordnung die abgestufte Steuerspannung für jeden Steuereingang des elektronischen Schalters bereitgestellt werden.

24. Schalteranordnung nach Anspruch 22 oder 23, bei der die Mehrzahl von n n-Typ-Feldeffekttransistoren (304, 306, 308) des elektronischen Schalters (302) in Triple-Well-Technik mit einem isolierten n-Typ-Wannenbereich aufgebaut sind.

25. Schalteranordnung nach Anspruch 24, bei der der n-Typ-Wannenbereich (416) der Mehrzahl von n Feldeffekttransistoren (304, 306, 308) bei dem ersten und zweiten Betriebszustand mit dem zweiten Ausgang (106b) der elektronischen Schaltung (106) verbunden ist.

26. Schalteranordnung nach einem der Ansprüche 21 bis 25, bei der das erste Bezugspotential (U_{bez1}) vorzugsweise Massepotential aufweist, und das zweite Bezugspotential (U_{bez2}) vorzugsweise der Betriebsspannung (V_{DD}) der elektronischen Schaltung (106) entspricht.

## Claims

1. Electronic switch arrangement (100) for switching a signal (U1) at a first output (106a) of an electronic circuit (106) through to an overall output (108), comprising:
a voltage divider arrangement (104) of at least two impedance elements (Z1, Z2), the voltage divider arrangement (104) comprising a first voltage divider terminal (104a), a second voltage divider terminal (104b), and a voltage divider tap (104c), the first voltage divider terminal (104a) being connected to the first output (106a) of the electronic circuit (106), and the second voltage divider terminal (106b) being connected to a reference potential (U_{ref}),
an electronic switch (102) comprising a first switch terminal (102a), a second switch terminal (102b), and a control input (102c), the first switch terminal (102a) being connected to the first output (106a) of the electronic circuit (106) and to the first voltage divider terminal (104a), and the second switch terminal (102b) being connected to a second output (106b) of the electronic circuit (106), and the control input (102c) being connected to the voltage divider tap (104c),
wherein in a first operating state of the electronic circuit (106), the signal (U₁) at the first output (106a) of same has a first voltage level (U₁₋₁) which, in terms of magnitude, is larger than a reference voltage (Vₚₚ) of the electronic circuit (106), and wherein in a second operating state of the electronic circuit (106), the signal (U₁) at the first output (106a) has a second voltage level (U₁₋₂) which, in terms of magnitude, is smaller than or equal to the reference voltage (Vₚₚ), and
wherein the impedance elements (Z1, Z2) of the voltage divider arrangement are dimensioned such that the voltage divider tap (104c) has a control voltage (V_{control}) provided thereat, the nature of which is such that in the first operating state, the electronic switch (102) switches the signal (U₁) through to the overall output (108) from the first switch terminal (102a), and in the second operating state, the electronic switch (102) disconnects the first output (106a) from the overall output (108).

2. Switch arrangement as claimed in claim 1, wherein the electronic switch (102) is a field-effect transistor of a first conductivity type having a drain terminal, a source terminal, a gate terminal and a bulk area, the source terminal being associated with the first switch terminal (102a), the drain terminal with the second switch terminal (102b), and the gate terminal with the control input (102c) of the electronic switch (102).

3. Switch arrangement as claimed in claim 2, wherein the field-effect transistor comprises an isolated bulk area.

4. Switch arrangement as claimed in claims 2 or 3, wherein the field-effect transistor comprises a gate/source breakdown voltage between its gate and source terminals, the voltage difference between the control input (102c) and the first switch terminal (102a) of the electronic switch (102) being smaller than or equal to the gate/source breakdown voltage both in the first and second operating states.

5. Switch arrangement as claimed in claim 4, wherein the gate/source breakdown voltage of the field-effect transistor corresponds to the reference voltage (V_{DD}).

6. Switch arrangement as claimed in claims 4 or 5, wherein the impedance elements (Z1, Z2) of the voltage divider arrangement (104) are dimensioned such that the voltage divider tap (104c) has a voltage level (V_{controll}) applied thereat which is smaller than or equal to the gate/source breakdown voltage of the field-effect transistor.

7. Switch arrangement as claimed in any of claims 2 to 6, wherein the field-effect transistor has, at its drain terminal, a drain breakdown voltage which corresponds to at least the first voltage level (U₁₋₁).

8. Switch arrangement as claimed in any of claims 1 to 7, wherein the reference potential (U_{ref}) applied at the second voltage divider terminal (104b) is ground potential, and wherein the reference voltage (V_{DD}) is the operating voltage of the electronic circuit (106).

9. Switch arrangement as claimed in any of claims 1 to 8, wherein the impedance elements (Z1, Z2) of the voltage divider arrangement (104) are resistive and/or capacitive circuit elements.

10. Switch arrangement as claimed in any of claims 1 to 9, further comprising:
a further voltage divider arrangement (212) of at least two impedance elements (Z3, Z4), the further voltage divider arrangement (212) comprising a third voltage divider terminal (212a), a fourth voltage divider terminal (212b), and a second voltage divider tap (212c), the third voltage divider terminal (212a) being connected to the second output (106b) of the electronic circuit (106), and the fourth voltage divider terminal (212b) being connected to a reference potential, and
a further electronic switch (210) comprising a third switch terminal (210a), a fourth switch terminal (210b), and a second control input (210c), the third switch terminal (210a) being connected to the second output (106b) of the electronic circuit (106) and to the third voltage divider terminal (212a) of the further voltage divider arrangement (212), and the fourth switch terminal (210b) being connected to the first output (106a) of the electronic circuit (106), and the second control input (210c) being connected to the second voltage divider tap (212c) of the further voltage divider arrangement (212),
wherein in the first operating state, a second signal (U₂) at the second output (106b) of the electronic circuit (106) comprises a third voltage level (U₂₋₁) which, in terms of magnitude, is smaller than or equal to the reference voltage (V_{DD}), and in the second operating state, the second signal (U₂) at the second output (106b) has a fourth voltage level (U₂₋₂) which, in terms of magnitude, is larger than the reference voltage (V_{DD}), and
wherein the impedance elements (Z3, Z4) of the further voltage divider arrangement (212) are dimensioned such that the second voltage divider tap (212c) of the further voltage divider arrangement (212) has a second control voltage (V_{control2}) provided thereat, so that in the first operating state, the further electronic switch (210) disconnects the second output (106b) of the electronic circuit (106) from the overall output (108) of the electronic switch arrangement (100), and so that in the second operating state, the further electronic switch (210) switches the second signal (U₂) at the second output (106b) through to the overall output (108) of the electronic switch arrangement (100) from the third switch terminal (210a) of the further electronic switch (210).

11. Switch arrangement as claimed in claim 10, wherein the further electronic switch (210) is a further field-effect transistor having a drain terminal, a source terminal, a gate terminal, and a bulk area, the source terminal being associated with the third switch terminal (310a), the drain terminal with the fourth switch terminal (310b), and the gate terminal with the second control input (310c) of the further electronic switch (210).

12. Switch arrangement as claimed in claim 11, wherein the further field-effect transistor (210) comprises an isolated bulk area.

13. Switch arrangement as claimed in any of claims 10 to 12, wherein the further field-effect transistor (210) comprises a gate/source breakdown voltage between its gate and source terminals, the voltage difference between the control input (210c) and the first switch terminal (210a) of the further electronic switch (210) being smaller than or equal to the gate/source breakdown voltage both in the first and second operating states.

14. Switch arrangement as claimed in claim 13, wherein the gate/source breakdown voltage of the further field-effect transistor corresponds to the reference voltage (V_{DD}).

15. Switch arrangement as claimed in claims 13 or 14, wherein the impedance elements (Z3, Z4) of the further voltage divider arrangement (212) are dimensioned such that the second voltage divider tap (212c) has a voltage level (V_{control2}) applied thereat which is smaller than or equal to the gate/source breakdown voltage of the further field-effect transistor (210).

16. Switch arrangement as claimed in any of claims 11 to 15, wherein the further field-effect transistor (210) has, at its drain terminal (210b), a drain breakdown voltage which corresponds to at least the first voltage level (U₁₋₁).

17. Switch arrangement as claimed in any of claims 10 to 16, wherein the reference potential (U_{ref}) applied at the second voltage divider terminal (212b) of the further voltage divider arrangement (212) is ground potential, and
wherein the reference voltage (V_{DD}) is the operating voltage of the electronic circuit (106).

18. Switch arrangement as claimed in any of claims 10 to 17, wherein the impedance elements (Z3, Z4) of the further voltage divider arrangement are resistive and/or capacitive circuit elements.

19. Switch arrangement as claimed in any of claims 1 to 18, wherein the electronic circuit (106) is a bipolar charge pump.

20. Switch arrangement as claimed in claim 19, wherein in the first operating state, the first voltage level (U₁₋₁) at the first output (106a) of the bipolar charge pump is a high negative voltage (V_{neg}), and the third voltage level (U₂₋₁) at the second output (106b) is between ground potential and the reference voltage (V_{DD}), and wherein in the second operating state, the second voltage level (U₁₋₂) at the first output (106a) is between ground potential and the reference voltage (V_{DD}), and a fourth voltage level (U₂₋₂) at the second output (106b) is a high positive voltage (Vₚₒₛ).

21. Switch arrangement as claimed in claim 20, wherein the field-effect transistor (102) of the electronic switch (100) is an n-type MOSFET, and the further field-effect transistor (210) of the further electronic switch (200) is a p-type MOSFET.

22. Switch arrangement as claimed in any of claims 1 to 21, the electronic switch (302) comprising a plurality of n n-type field-effect transistors (304, 306, 308), n being the number of field-effect transistors, the n n-type field-effect transistors (304, 306, 308) forming a cascode circuit, the source terminal of the first n-type field-effect transistor being associated with the first switch terminal, and the drain terminal of the n^{th} n-type field-effect transistor being associated with the second switch terminal, and each n-type field-effect transistor comprising a gate terminal, and each gate terminal having a control input of the electronic switch associated with it,
each control input of the electronic switch (302) being driven by a control voltage, the control voltage between the plurality of n n-type field-effect transistors (304, 306, 308) graded such that the cascode circuit of the plurality of field-effect transistors is conductive during the first operating state, and that the cascode circuit is non-conductive in the second operating state, and that the gate/source voltage between the gate and source terminals of each field-effect transistor of the cascode, and the drain/source voltage between the drain and source terminals of each field-effect transistor of the cascode, and the gate/channel voltage between the gate terminal and the channel area of each field-effect transistor of the cascode are smaller than or equal to the reference voltage.

23. Switch arrangement as claimed in claim 22, wherein the voltage divider arrangement comprises a plurality of n+1 impedance elements (Z0-Z4) and n voltage divider taps, and further the further voltage divider arrangement comprises a plurality of n+1 impedance elements (Z5-Z9) and n voltage divider taps, the first output of the electronic circuit being connected to the first voltage divider terminal of the voltage divider arrangement, and in the first operating state, a first reference potential (U_{ref}) being connected to the second voltage divider terminal, the plurality of n voltage divider taps of the voltage divider arrangement being connected to the respective control inputs of the electronic switch (302),
the second output of the electronic circuit (106) being connected to the first voltage divider terminal of the further voltage divider arrangement, and in the second operating state, a second reference voltage (U_{ref2}) being connected to the second voltage divider terminal of the further voltage divider arrangement, the plurality of n voltage divider taps of the further voltage divider arrangement being connected to the respective control inputs of the electronic switch (302),
the impedance elements (Z0-Z4) of the voltage divider arrangement, and the impedance elements (Z5-Z9) of the further voltage divider arrangement being dimensioned such that in the first and second operating states, the graded control voltage for each control input of the electronic switch is provided at the central taps of the voltage divider arrangement and the further voltage divider arrangement.

24. Switch arrangement as claimed in claims 22 or 23, wherein the plurality of n n-type field-effect transistors (304, 306, 308) of the electronic switch (302) are built by means of triple-well technique comprising an isolated n-type trough area.

25. Switch arrangement as claimed in claim 24, wherein in the first and second operating states, the n-type trough area (416) of the plurality of n field-effect transistors (304, 306, 308) is connected to the second output (106b) of the electronic circuit (106).

26. Switch arrangement as claimed in any of claims 21 to 25, wherein the first reference potential (U_{ref1}) preferably comprises ground potential, and the second reference potential (U_{ref2}) preferably corresponds to the operating voltage (V_{DD}) of the electronic circuit (106).

## Revendications

1. Commutateur électronique (100) pour transmettre un signal (U1) présent à une première sortie (106a) à un circuit électronique (106) vers une sortie globale (108), aux caractéristiques suivantes:
un aménagement diviseur de tension (104) composé d'au moins deux éléments d'impédance (Z1, Z2), l'aménagement diviseur de tension (104) présentant une première connexion de diviseur de tension (104a), une deuxième connexion de diviseur de tension (104b) et une sortie de diviseur de tension (104c), la première connexion de diviseur de tension (104a) étant reliée à la première sortie (106a) du circuit électronique (106), et la deuxième connexion de diviseur de tension (106b) étant reliée à un potentiel de référence (U_{bez}),
un commutateur électronique (102) avec une première connexion de commutateur (102a), une deuxième connexion de commutateur (102b) et une entrée de commande (102c), la première connexion de commutateur (102a) étant reliée à la première sortie (106a) du circuit électronique (106) et à la première connexion de diviseur de tension (104a), et la deuxième connexion de commutateur (102b) étant reliée à une deuxième sortie (106b) du circuit électronique (106), et l'entrée de commande (102c) étant reliée à la sortie de diviseur de tension (104c),
le signal (U₁) présentant, dans un premier état de fonctionnement du circuit électronique (106), à la première sortie (106a) de ce dernier un premier niveau de tension (U₁₋₁) qui est, en quantité, supérieur à une tension de référence (Vₚₚ) du circuit électronique (106) et le signal (U₁) présentant, dans un deuxième état de fonctionnement du circuit électronique (106), à la première sortie (106a) un deuxième niveau de tension (U₁₋₂) qui est, en quantité, inférieur ou égal la tension de référence (Vₚₚ), et
les éléments d'impédance (Z1, Z2) de l'aménagement diviseur de tension étant dimensionnés de sorte que soit mise à disposition, à la sortie de diviseur de tension (104c), une tension de commande (Vₛₜₑᵤₑᵣ) qui est telle que le commutateur électronique (102) transmette, dans le premier état de fonctionnement, le signal (U₁) de la première connexion de commutateur (102a) à la sortie globale (108), et que le commutateur électronique (102) sépare, dans le deuxième état de fonctionnement, la première sortie (106a) de la sortie globale (108).

2. Commutateur selon la revendication 1, dans lequel le commutateur électronique (102) est un transistor à effet de champ d'un premier type de conductivité avec une connexion de drain, une connexion de source, une connexion de porte et une zone de masse, la connexion de source étant associée à la première connexion de commutateur (102a), la connexion de drain à la deuxième connexion de commutateur (102b) et la connexion de porte à l'entrée de commande (102c) du commutateur électronique (102).

3. Commutateur selon la revendication 2, dans lequel le transistor à effet de champ présente une zone de masse isolée.

4. Commutateur selon la revendication 2 ou 3, dans lequel le transistor à effet de champ présente, entre sa connexion de porte et sa connexion de source, une tension de rupture de porte/source, la différence de tension entre l'entrée de commande et la première connexion de commutateur (102a) du commutateur électronique (102) étant, tant dans le premier que dans le deuxième état de fonctionnement, inférieure ou égale à la tension de rupture de porte/source.

5. Commutateur selon la revendication 4, dans lequel la tension de rupture de porte/ source du transistor à effet de champ correspond à la tension de référence (V_{DD}).

6. Commutateur selon la revendication 4 ou 5, dans lequel les éléments d'impédance (Z1, Z2) de l'aménagement diviseur de tension (104) sont dimensionnés de sorte que soit présent à la sortie de diviseur de tension (104c) un niveau de tension (Vₛₜₑᵤₑᵣ₁) qui est inférieur ou égal à la tension de rupture de porte/source du transistor à effet de champ.

7. Commutateur selon l'une des revendications 2 à 6, dans lequel le transistor à effet de champ présente, à sa connexion de drain, une tension de rupture de drain correspondant au moins au premier niveau de tension (U₁₋₁).

8. Commutateur selon l'une des revendications 1 à 7, dans lequel le potentiel de référence (U_{bez}) présent à la deuxième connexion de diviseur de tension (104b) est le potentiel de masse, et
dans lequel la tension de référence (V_{DD}) est la tension de fonctionnement du circuit électronique (106).

9. Commutateur selon l'une des revendications 1 à 8, dans lequel les éléments d'impédance (Z1, Z2) de l'aménagement diviseur de tension (104) sont des éléments de circuit résistifs et/ou capacitifs.

10. Commutateur selon l'une des revendications 1 à 9, présentant par ailleurs les caractéristiques suivantes:
un autre aménagement diviseur de tension (212) composé d'au moins deux éléments d'impédance (Z3, Z4), l'autre aménagement diviseur de tension (212) présentant une troisième connexion de diviseur de tension (212a), une quatrième connexion de diviseur de tension (212b) et une deuxième sortie de diviseur de tension (212c), la troisième connexion de diviseur de tension (212a) étant reliée à la deuxième sortie (106b) du circuit électronique (106), et la quatrième connexion de diviseur de tension (212b) étant reliée à un potentiel de référence, et
un autre commutateur électronique (210) avec une troisième connexion de commutateur (210a), une quatrième connexion de commutateur (210b) et une deuxième entrée de commande (210c), la troisième connexion de commutateur (210a) étant reliée à la deuxième sortie (106b) du circuit électronique (106) et à la troisième connexion de diviseur de tension (212a) de l'autre aménagement diviseur de tension (212), et la quatrième connexion de commutateur (210b) étant reliée à la première sortie (106a) du circuit électronique (106), et la deuxième entrée de commande (210c) étant reliée à la deuxième sortie de diviseur de tension (212c) du deuxième aménagement diviseur de tension (212),
un deuxième signal (U₂) à la deuxième sortie (106b) du circuit électronique (106) présentant, dans le premier état de fonctionnement, un troisième niveau de tension (U₂₋₁) qui est, en quantité, inférieur ou égal à la tension de référence (V_{DD}) et le deuxième signal (U₂) à la deuxième sortie (106b) présentant, dans le deuxième état de fonctionnement, un quatrième niveau de tension (U₂₋₂) qui est, en quantité, supérieur à la tension de référence (V_{DD}), et
les éléments d'impédance (Z3, Z4) de l'autre aménagement diviseur de tension (212) étant dimensionnés de sorte que soit mise à disposition, à la deuxième sortie de diviseur de tension (212c) de l'autre aménagement diviseur de tension (212), une deuxième tension de commande (V steuer2), de sorte que l'autre commutateur électronique (210) sépare, dans le premier état de fonctionnement, la deuxième sortie (106b) du circuit électronique (106) de la sortie globale (108) du commutateur électronique (100), et que l'autre commutateur électronique (210) transmette, dans le deuxième état de fonctionnement, le deuxième signal (U2) présent à la deuxième sortie (106b) de la troisième connexion de commutateur (210a) de l'autre commutateur électronique (210) à la sortie globale (108) du commutateur électronique (100).

11. Commutateur selon la revendication 10, dans lequel l'autre commutateur électronique (210) est un autre transistor à effet de champ avec une connexion de drain, une connexion de source, une connexion de porte et une zone de masse, la connexion de source étant associée à la troisième connexion de commutateur (310a), la connexion de drain à la quatrième connexion de commutateur (310b) et la connexion de porte à la deuxième entrée de commande (310c) de l'autre commutateur électronique (210).

12. Commutateur selon la revendication 11, dans lequel l'autre transistor à effet de champ (210) présente une zone de masse isolée.

13. Commutateur selon l'une des revendications 10 à 12, dans lequel l'autre transistor à effet de champ (210) présente, entre sa connexion de porte et sa connexion de source, une tension de rupture de porte/source, la différence de tension entre l'entrée de commande (210c) et la première connexion de commutateur (210a) de l'autre commutateur électronique (210) étant, tant dans le premier que dans le deuxième état de fonctionnement, inférieure ou égale à la tension de rupture de porte/source.

14. Commutateur selon la revendication 13, dans lequel la tension de rupture de porte/source de l'autre transistor à effet de champ correspond à la tension de référence (V_{DD}).

15. Commutateur selon la revendication 13 ou 14, dans lequel les éléments d'impédance (Z3, Z4) de l'autre aménagement diviseur de tension (212) sont dimensionnés de sorte que soit présent, à la deuxième sortie de diviseur de tension (212c), un niveau de tension (Vₛₜₑᵤₑᵣ₂) qui est inférieure ou égale à la tension de rupture de porte/source de l'autre transistor à effet de champ (210).

16. Commutateur selon l'une des revendications 11 à 15, dans lequel l'autre transistor à effet de champ (210) présente, à sa connexion de drain (210b), une tension de rupture de drain correspondant au moins au premier niveau de tension (U₁₋₁).

17. Commutateur selon l'une des revendications 10 à 16, dans lequel le potentiel de référence (U_{bez}) présent à la deuxième connexion de diviseur de tension (212b) du deuxième aménagement diviseur de tension (212) est le potentiel de masse, et
dans lequel la tension de référence (V_{DD}) est la tension de fonctionnement du circuit électronique (106).

18. Commutateur selon l'une des revendications 10 à 17, dans lequel les éléments d'impédance (Z3, Z4) de l'autre aménagement diviseur de tension sont des éléments de circuit résistifs et/ou capacitifs.

19. Commutateur selon l'une des revendications 1 à 18, dans lequel le circuit électronique (106) est une pompe de charge bipolaire.

20. Commutateur selon la revendication 19, dans lequel le premier niveau de tension (U₁₋₁) à la première sortie (106a) de la pompe de charge bipolaire est, dans le premier état de fonctionnement, une haute tension négative (V_{neg}), et le troisième niveau de tension (U₂₋₁) à la deuxième sortie (106b) se situe entre le potentiel de masse et la tension de référence (V_{DD}), et le deuxième niveau de tension (U₁₋₂) à la première sortie (106a) se trouvant, dans le deuxième état de fonctionnement, entre le potentiel de masse et la tension de référence (V_{DD}), et un quatrième niveau de tension (U₂₋₂) à la deuxième sortie (106b) étant une haute tension positive (Vₚₒₛ).

21. Commutateur selon la revendication 20, dans lequel le transistor à effet de champ (102) du commutateur électronique (100) est un MOSFET de type n et l'autre transistor à effet de champ (210) de l'autre commutateur électronique (200) est un MOSFET de type p.

22. Commutateur selon l'une des revendications 1 à 21, le commutateur électronique (302) présentant une pluralité de n transistors à effet de champ de type n (304, 306, 308), n étant le nombre de transistors à effet de champ, les n transistors à effet de champ de type n (304, 306, 308) formant un circuit en cascade, la connexion de source du premier transistor à effet de champ de type n étant associée à la première connexion de commutateur, et la connexion de drain du n-ième transistor à effet de champ de type n étant associée à la deuxième connexion de commutateur, et chaque transistor à effet de champ de type n présentant une connexion de porte, et à chaque connexion de porte étant associée une entrée de commande du commutateur électronique,
chaque entrée de commande du commutateur électronique (302) étant activée par une tension de commande, la tension de commande étant étagée entre la pluralité de n transistors à effet de champ de type n (304, 306, 308) de sorte que le circuit en cascade composé de la pluralité de transistors à effet de champ soit conducteur pendant le premier état de fonctionnement, et que le circuit en cascade soit bloquant dans le deuxième état de fonctionnement, et que la tension de porte/source entre la connexion de porte et la connexion de source de chaque transistor à effet de champ de la cascade et la tension de drain/source entre la connexion de drain et la connexion de source de chaque transistor à effet de champ de la cascade et la tension de porte/canal entre la connexion de porte et la zone de canal de chaque transistor à effet de champ de la cascade soient inférieures ou égales à la tension de référence.

23. Commutateur selon la revendication 22, dans lequel l'aménagement diviseur de tension présente une pluralité de n+ 1 éléments d'impédance (Z0 à Z4) et n sorties de diviseur de tension et, par ailleurs, l'autre aménagement diviseur de tension présente une pluralité de n+1 éléments d'impédance (Z5 à Z9) et n sorties de diviseur de tension, la première sortie du circuit électronique étant reliée à la première connexion de diviseur de tension de l'aménagement diviseur de tension, et un premier potentiel de référence (U_{bez}) étant, dans le premier état de fonctionnement, relié à la deuxième connexion de diviseur de tension, la pluralité de n sorties de diviseur de tension de l'aménagement diviseur de tension étant reliées aux entrées de commande respectives du commutateur électronique (302),
la deuxième sortie du circuit électronique (106) étant reliée à la première connexion de pilotage de tension de l'autre aménagement diviseur de tension, et une deuxième tension de référence (U_{bez2}) étant reliée, dans le deuxième état de fonctionnement, à la deuxième connexion de diviseur de tension de l'autre aménagement diviseur de tension, la pluralité de n sorties de diviseur de tension de l'autre aménagement diviseur de tension étant reliées aux entrées de commande respectives du commutateur électronique (302),
les éléments d'impédance (Z0 à Z4) de l'aménagement diviseur de tension et les éléments d'impédance (Z5 à Z9) de l'autre aménagement diviseur de tension étant dimensionnés de sorte que dans le premier et le deuxième état de fonctionnement soit mise à disposition, aux sorties centrales de l'aménagement diviseur de tension et de l'autre aménagement diviseur de tension, la tension de la tension de commande pour chaque entrée de commande du commutateur électronique.

24. Commutateur selon la revendication 22 ou 23, dans lequel la pluralité de n transistors à effet de champ de type n (304, 306, 308) du commutateur électronique (302) sont construits selon la technique à trois puits avec une zone de cuvette de type n isolée.

25. Commutateur selon la revendication 24, dans lequel la zone de cuvette de type n (416) de la pluralité de n transistors à effet de champ (304, 306, 308} est reliée, dans le premier et le deuxième état de fonctionnement, à la deuxième sortie (106b) du circuit électronique (106).

26. Commutateur selon l'une des revendications 21 à 25, dans lequel le premier potentiel de référence (U_{bez1}) présente, de préférence, un potentiel de masse, et le deuxième potentiel de référence (U_{bez2}) correspond, de préférence, à la tension de fonctionnement (V_{DD}) du circuit électronique (106).
